# EUROPEAN PATENT APPLICATION

(11) **EP 4 468 109 A1**
(43) Date of publication of application: **27.11.2024**
(21) Application number: 22830353.3
(22) Date of filing: 23.12.2022
(51) Int. Cl.: G06F 1/16, H04M 1/02, H05K 5/06

(54) **ELECTRONIC DEVICE COMPRISING STRUCTURE FOR PREVENTING INFLOW OF FOREIGN SUBSTANCES**

(30) Priority: 30.03.2022 KR 20220039955; 24.06.2022 KR 20220077876
(71) Applicant: Samsung Electronics Co., Ltd., Suwon-si, Gyeonggi-do 16677 (KR)
(72) Inventor: KANG, Youngmin, Suwon-si, Gyeonggi-do 16677 (KR); SHIN, Moonchul, Suwon-si, Gyeonggi-do 16677 (KR); YOON, Yeonggyu, Suwon-si, Gyeonggi-do 16677 (KR); CHO, Joongyeon, Suwon-si, Gyeonggi-do 16677 (KR); CHOI, Junyoung, Suwon-si, Gyeonggi-do 16677 (KR); YOON, Byounguk, Suwon-si, Gyeonggi-do 16677 (KR); LEE, Junghyeob, Suwon-si, Gyeonggi-do 16677 (KR); CHO, Sunggun, Suwon-si, Gyeonggi-do 16677 (KR)
(74) Representative: Gulde & Partner
(86) International application number: PCT/KR2022/021217
(87) International publication number: WO 2023/191255

(57) **Abstract**

According to an embodiment, an electronic device includes a first housing, a second housing slidable with respect to the first housing, a display sliding into the first housing or sliding out from the first housing, a plurality of supporting bars disposed on one surface of the flexible display, a plurality of barriers disposed on an one end of each of the plurality of support bars, and facing the side surface of the flexible display, and a plurality of guiding protrusions extending from each of the plurality of supporting bars in a direction opposite to the extending direction of the plurality of barriers wherein a gap between the side surfaces of each of the plurality of barriers facing each other is smaller than a gap between the plurality of guiding protrusions.

## Description

### [Technical Field]

Various embodiments relate to an electronic device including a structure for preventing inflow of foreign materials.

### [Background Art]

In order for the user to easily carry an electronic device, the electronic device may be miniaturized. Although the electronic device is miniaturized, there is an increasing need for an electronic device in which the size of a display for displaying content can be changed so that a user can receive various contents through the electronic device. For example, the electronic device may include a flexible display in which the size of the display exposed to the outside of the electronic device can be changed.

### [Disclosure]

### [Technical Problem]

In the flexible display of the electronic device, for example, a region of the display visible from the outside of the electronic device may be expanded or contracted according to the movement of the housing. A gap may be formed between the housing and the display so that the display may move according to the movement of the housing. A foreign material that flow into the electronic device through the gap between the housing and the display may damage internal components of the electronic device. The electronic device according to various embodiments may include a structure for preventing inflow of a foreign material through the gap between the housing and the display.

The technical problems to be achieved in this document are not limited to those described above, and other technical problems not mentioned herein will be clearly understood by those having ordinary knowledge in the art to which the present disclosure belongs, from the following description.

### [Technical Solution]

According to an embodiment, an electronic device may include a first housing; a second housing coupled to the first housing to be slidable with respect to the first housing; a display including a first region disposed on a surface of the second housing and a second region deformable by a movement of the second housing, and movable by the movement of the second housing; and a guiding member including a first supporting bar and a second supporting bar extending in a direction parallel to one surface of the display on the one surface of the display, spaced apart from each other, and disposed on the display, wherein the guiding member may include a first barrier extending from at least one of both ends of the supporting bar in a direction perpendicular to the one surface of the display. According to an embodiment, the guiding member may include a second barrier extending from at least one of both ends of the second supporting bar in the direction perpendicular to the one surface of the display, and spaced apart from the first barrier. According to an embodiment, the first barrier and the second barrier may face the side surface of the display parallel to the moving direction of the display, and at least a part of the first barrier and the second barrier may overlap each other when the display is viewed from a side surface of the display.

According to an embodiment, an electronic device may include a first housing; a second housing coupled to the first housing to be slidable with respect to the first housing; a display including a first region disposed on a surface of the second housing and a second region deformable by a movement of the second housing, and movable by the movement of the second housing; and a guiding member including a first supporting bar and a second supporting bar extending in a direction parallel to one surface of the display on the one surface of the display, spaced apart from each other, and disposed on the display. According to an embodiment, the guiding member may include a first barrier extending from at least one of both ends of the supporting bar in a direction perpendicular to the one surface of the display, wherein the first barrier may include a first extending portion facing the second region and extending in a direction parallel to a moving direction of the display, and a second extending portion parallel to the first barrier and extending longer than the first extending portion. According to an embodiment, the guiding member may include a second barrier extending from at least one of both ends of the second supporting bar in the direction perpendicular to the one surface of the display, wherein the second barrier may include a third extending portion facing the second region and extending in the direction parallel to the moving direction of the display, and a fourth extending portion parallel to the third extending portion and extending shorter than the third extending portion. According to an embodiment, at least a part of the second extending portion may overlap to at least a part of the third extending portion when the display is viewed from a side surface of the display parallel to the moving direction of the display. According to an embodiment, the first barrier and the second barrier overlap to a part of the first housing when the display is viewed from above.

### [Advantageous Effects]

The electronic device according to an embodiment can provide a structure for preventing a foreign material from inflowing between the housing and the display by the barrier disposed to face the side surface of the display.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a block diagram of an electronic device in a network environment according to various embodiments.
FIG. 2A is a front view of a first state of an electronic device according to an embodiment.
FIG. 2B is a rear view of a first state of an electronic device according to an embodiment.
FIG. 2C is a front view of a second state of an electronic device according to an embodiment.
FIG. 2D is a rear view of a second state of an electronic device according to an embodiment.
FIG. 3A is an exploded perspective view of an electronic device according to an embodiment.
FIG. 3B is a cross-sectional view illustrating an example in which an electronic device according to an embodiment is cut along A-A' of FIG. 2A.
FIG. 4A is a perspective view of a second state of an electronic device according to an embodiment.
FIG. 4B is a cross-sectional view illustrating an example in which an electronic device according to an embodiment is cut along B-B' of FIG. 4A.
FIG. 4C is a cross-sectional view illustrating an example in which an electronic device according to an embodiment is cut along C-C' of FIG. 4A.
FIG. 5A is a front view of a guiding member and a display of an electronic device according to an embodiment.
FIG. 5B is a cross-sectional view illustrating an example in which a guiding member and a display of an electronic device according to an embodiment are cut along D-D' of FIG. 5A.
FIG. 6A is a front view of a guiding member and a display of an electronic device according to an embodiment.
FIG. 6B is a cross-sectional view illustrating an example in which a guiding member and a display of an electronic device according to an embodiment are cut along E-E' of FIG. 6A.
FIG. 7 is an enlarged perspective view illustrating a guiding member and a display of an electronic device according to an embodiment.
FIG. 8 is a cross-sectional view illustrating an example in which a guiding member and a display of an electronic device according to an embodiment are cut along F-F' of FIG. 7.
FIG. 9 is a partial exploded perspective view of an electronic device according to an embodiment.

### [Mode for Invention]

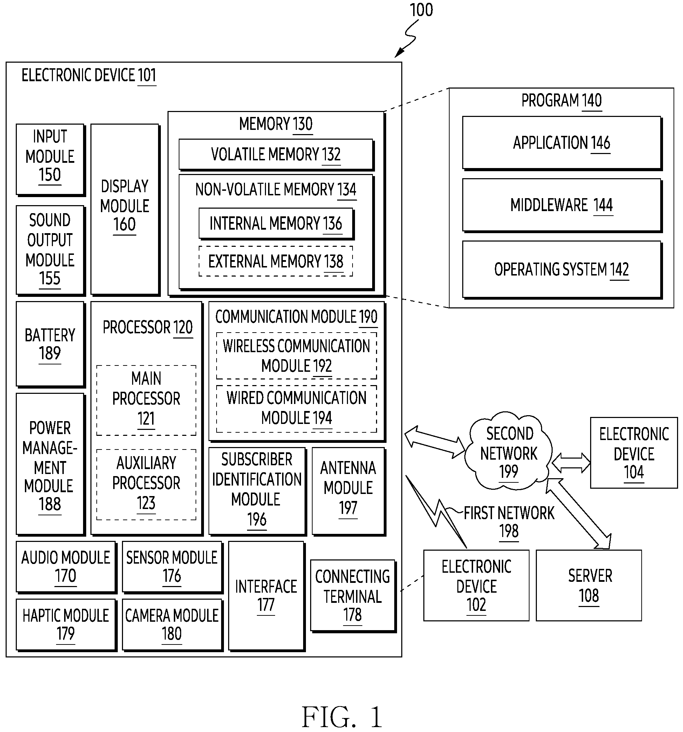

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

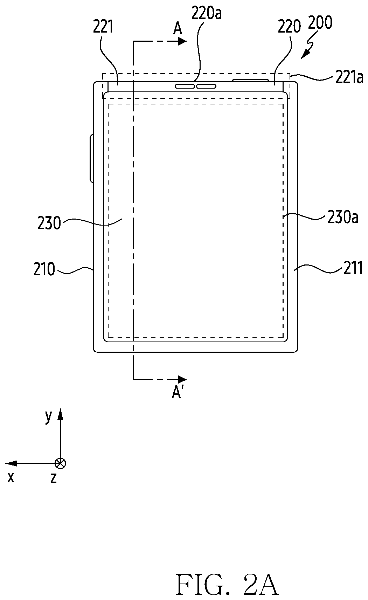

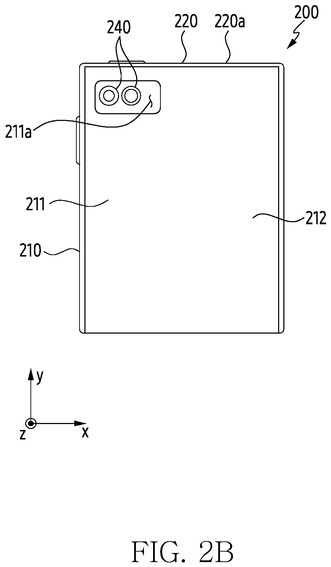

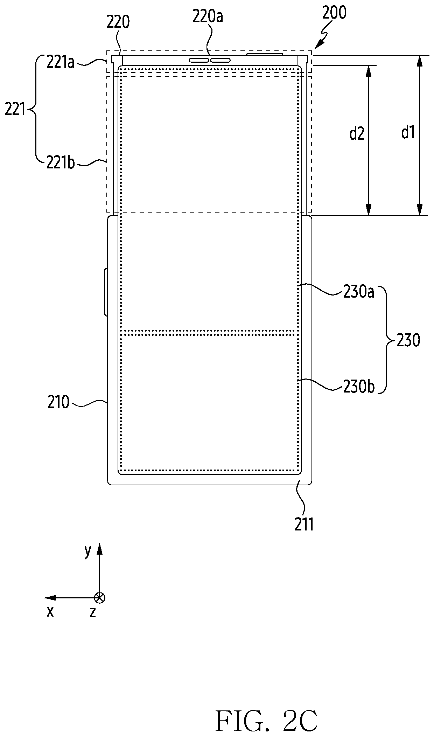

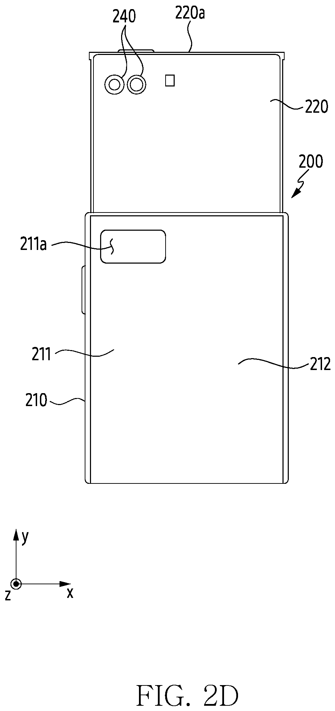

FIG. 2A is a front view of a first state of an electronic device according to an embodiment, FIG. 2B is a rear view of a first state of an electronic device according to an embodiment, FIG. 2C is a front view of a second state of an electronic device according to an embodiment, and FIG. 2D is a rear view of a second state of an electronic device according to an embodiment.

Referring to FIGS. 2A, 2B, 2C, and 2D, an electronic device 200 (e.g., the electronic device 101 in FIG. 1) according to an embodiment includes a first housing 210, a second housing 220, a display 230 (e.g., the display module 160 in FIG. 1), and a camera 240 (e.g., the camera module 180 in FIG. 1). The electronic device 200, however, is not limited thereto. For example, the camera 240 may also be omitted. According to an embodiment, the second housing 220 is slidable with respect to the first housing 210. For example, the second housing 220 may move within a specified distance along a first direction (e.g., the +y direction) with respect to the first housing 210. When the second housing 220 moves in the first direction, a distance between the side surface 220a of the second housing 220 facing the first direction and the first housing 210 may increase. For another example, the second housing 220 may move in a range within a specified distance along a second direction (e.g., the -y direction) opposite to the first direction with respect to the first housing 210. When the second housing 220 moves in the second direction, a distance between the side surface 220a of the second housing 220 facing the first direction and the first housing 210 may decrease. According to an embodiment, the second housing 220 may linearly reciprocate with respect to the first housing 210 by sliding relative with respect to the first housing 210. For example, at least a part of the second housing 220 may be inserted into the first housing 210 or may be pulled out from the first housing 210.

According to an embodiment, the electronic device 200 may be referred to as a "slidable electronic device" as the second housing 220 is designed to be slidable with respect to the first housing 210. According to an embodiment, the electronic device 200 may be referred to as a "rollable electronic device" as at least a part of the display 230 is designed to be rolled into the second housing 220 (or the first housing 210) based on the slide movement of the second housing 220.

According to an embodiment, the first state of the electronic device 200 may be defined as a state in which the second housing 220 moves in the second direction (e.g., a contracted state or a slide-in state). For example, in the first state of the electronic device 200, the second housing 220 may be movable in the first direction but may not be movable in the second direction. In the first state of the electronic device 200, a distance between the side surface 220a of the second housing 220 and the first housing 210 may increase as the second housing 220 moves, but may not decrease. For another example, in the first state of the electronic device 200, a part of the second housing 220 may be pulled out from the first housing 210, but may not be inserted. According to an embodiment, the first state of the electronic device 200 may be defined as a state in which the second region 230b of the display 230 is not visually exposed from the outside of the electronic device 200. For example, in the first state of the electronic device 200, the second region 230b of the display 230 may be located inside the inner space (not shown) of the electronic device 200 formed by the first housing 210 and/or the second housing 220, and may not be visible from the outside of the electronic device 200.

According to an embodiment, the second state of the electronic device 200 may be defined as a state in which the second housing 220 moves in the first direction (e.g., an extended state or a slide-out state). For example, in the second state of the electronic device 200, the second housing 220 may be movable in the second direction but may not be movable in the first direction. In the second state of the electronic device 200, a distance between the side surface 220a of the second housing 220 and the first housing 210 may decrease as the second housing 220 moves, but may not increase. For another example, in the second state of the electronic device 200, a part of the second housing 220 may be inserted into the first housing 210, but may not be pulled out from the first housing 210. According to an embodiment, the second state of the electronic device 200 may be defined as a state in which the second region 230b of the display 230 is visually exposed from the outside of the electronic device 200. For example, in the second state of the electronic device 200, the second region 230b of the display 230 may be pulled out from the inner space of the electronic device 200 and visible from the outside of the electronic device 200.

According to an embodiment, when the second housing 220 moves in the first direction from the first housing 210, at least a part of the second housing 220 and/or the second region 230b of the display 230 may be pulled out from the first housing 210 by a pulled-out length d1 corresponding to the moving distance of the second housing 220. According to an embodiment, the second housing 220 may reciprocate within a specified distance d1. According to an embodiment, a pulled-out length d2 may have a size of approximately 0 to a specified distance d1.

According to an embodiment, the state of the electronic device 200 may be convertible between the second state and/or the first state, by manual operation by a user or automatic operation by a driving module (not shown) disposed inside the first housing 210 or the second housing 220. According to an embodiment, the driving module may trigger an operation based on a user input. According to an embodiment, the user input for triggering the operation of the driving module may include a touch input, a force touch input, and/or a gesture input through the display 230. According to another embodiment, the user input for triggering the operation of the driving module may include an audio input (voice input) or an input of a physical button exposed to the outside of the first housing 210 or the second housing 220. According to an embodiment, the driving module may be driven in a semi-automatic manner, in which an operation is triggered when a manual operation by a user's external force is detected.

According to an embodiment, the first state of the electronic device 200 may be referred to as a first shape, and the second state of the electronic device 200 may be referred to as a second shape. For example, the first shape may include a normal state, a contracted state, or a closed state, and the second shape may include an open state. According to an embodiment, the electronic device 200 may form a third state (e.g., an intermediate state) that is a state between the first state and the second state. For example, the third state may be referred to as a third shape, and the third shape may include a free stop state.

According to an embodiment, the display 230 may be visible(or viewable) from the outside through a front direction (e.g., the -z direction) of the electronic device 200 so that visual information may be displayed to the user. For example, the display 230 may include a flexible display. According to an embodiment, the display 230 may be disposed in the second housing 220 and may be pulled out from the inner space (not shown) of the electronic device 200 or inserted into the inner space of the electronic device 200 according to the movement of the second housing 220. The inner space of the electronic device 200 may mean a space in the first housing 210 and the second housing 220 formed by the combination of the first housing 210 and the second housing 220. For example, in the first state of the electronic device 200, at least a part of the display 230 may be rolled into and inserted into the inner space of the electronic device 200. When the second housing 220 moves in the first direction while at least a part of the display 230 is inserted into the inner space of the electronic device 200, at least a part of the display 230 may be pulled out from the inner space of the electronic device 200. For another example, when the second housing 220 moves in the second direction, at least a part of the display 230 may be rolled into the inner space of the electronic device 200, and thus may be inserted into the inner space of the electronic device 200. As at least a part of the display 230 is pulled out or inserted, the region of the display 230 visible from the outside of the electronic device 200 may be expanded or contracted. According to an embodiment, the display 230 may include a first region 230a and a second region 230b.

According to an embodiment, the first region 230a of the display 230 may mean a region of the display 230 that may be fixedly visible from the outside of the electronic device 200, regardless of whether the electronic device 200 is in the second state or the first state. For example, the first region 230a may mean a partial region of the display 230 that is not rolled into the inner space of the electronic device 200. According to an embodiment, when the second housing 220 moves, the first region 230a may move together with the second housing 220. For example, when the second housing 220 moves in the first or second direction, the first region 230a may move in the first or second direction on the front surface of the electronic device 200 together with the second housing 220.

According to an embodiment, the second region 230b of the display 230 may be connected to the first region 230a, and may be inserted into the inner space of the electronic device 200 or pulled out from the inner space of the electronic device 200 as the second housing 220 moves. For example, in the first state of the electronic device 200, the second region 230b of the display 230 may be in a rolled state and inserted into the inner space of the electronic device 200. In the first state of the electronic device 200, the second region 230b of the display 230 may be inserted into the inner space of the electronic device 200 and thus may not be visible from the outside. For another example, in the second state of the electronic device 200, the second region 230b of the display 230 may be pulled out from the inner space of the electronic device 200. The second region 230b of the display 230 may be visible from the outside of the electronic device 200 in the second state.

According to an embodiment, in the first state of the electronic device 200, the region of the display 230 visible from the outside of the electronic device 200 may include only the first region 230a of the display 230. The region of the display 230 visible from the outside of the electronic device 200 in the second state of the electronic device 200 may include at least a part of the first region 230a and the second region 230b of the display 230. According to an embodiment, the region of the display 230 visible from the outside of the electronic device 200 in the third state of the electronic device 200 may be smaller than the region of the display 230 visible from the outside of the electronic device 200 in the second state of the electronic device 200. For example, the region of the display 230 visible from the outside of the electronic device 200 in the third state of the electronic device 200 may include a part of the first region 230a and the second region 230b of the display 230.

According to an embodiment, the first housing 210 of the electronic device 200 may include a book cover 211 surrounding the inner space of the first housing 210 and a rear plate 212 surrounding the rear surface of the book cover 211. The second housing 220 of the electronic device 200 may include a front cover 221 surrounding the inner space of the electronic device 200.

According to an embodiment, the front cover 221 may include a first cover region 221a of the front cover 221 that is not inserted into the first housing 210, and a second cover region 221 that is inserted into the first housing 210 or pulled out from the inside of the first housing 210. Regardless of whether the electronic device 200 is in the second state and the first state, the first cover region 221a of the front cover 221 may be visible. According to an embodiment, at least a part of the first cover region 221a of the front cover 221 may form a side surface 220a of the second housing 220. According to an embodiment, the second cover region 221b of the second housing 220 may not be visible in the first state, but may be visible in the second state.

The camera 240 may obtain an image of a subject based on receiving light from the outside of electronic device 200. According to an embodiment, the camera 240 may include one or a plurality of lenses, an image sensor, and/or an image signal processor. According to an embodiment, the camera 240 may be disposed in the second housing 220 to face the rear surface of the electronic device 200 opposite to the front surface of the electronic device 200 on which the first region 230a of the display 230 is disposed. For example, the camera 240 may be disposed on the front cover 221 of the second housing 220 and at least partially visible from the outside of the electronic device 200 through an opening 211a formed in the book cover 211 when the electronic device 200 is in the first state. For another example, the camera 240 may be disposed on the front cover 221 of the second housing 220, and covered by the book cover 211 and/or the rear plate 212 when the electronic device 200 is in the first state, so that it may not be visible from the outside of the electronic device 200.

According to an embodiment, the camera 240 may include a plurality of cameras. For example, the camera 240 may include a wide-angle camera, an ultra-wide-angle camera, a telephoto camera, a proximity camera, and/or a depth camera. However, the camera 240 is not necessarily limited to including a plurality of cameras, and may include one camera.

According to an embodiment, the camera 240 may further include a camera (not shown) facing the front of the electronic device 200 on which the first region 230a of the display 230 is disposed. When the camera 240 faces the front of the electronic device 200, the camera 240 may be an under display camera (UDC) disposed under the display 230 (e.g., the +z direction from the display 230), but is not limited thereto.

According to an embodiment, the electronic device 200 may include a sensor module (not shown) (e.g., the sensor module 176 of FIG. 1) and/or a camera module (not shown) (e.g., the camera module 180 of FIG. 1) disposed under the display 230. The sensor module may detect an external environment based on information (e.g., light) received through the display 230. According to an embodiment, the sensor module may include at least one of a proximity sensor, an ultrasonic sensor, a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, a motor encoder, or an indicator. According to an embodiment, at least a part of sensor module of the electronic device 200 may be visually exposed to the outside through a part of regions of the display 230. According to an embodiment, the electronic device 200 may detect a pulled out length (e.g., a length d2) corresponding to a moving distance of the second housing 220 by using the sensor module. According to an embodiment, the electronic device 200 may generate pulled-out information on the degree of pulled-out detected by the sensor. For example, the electronic device 200 may detect and/or identify the degree to which the second housing 220 is pulled out by using the pulled out information. According to an embodiment, the pulled-out information may include information on a pulled-out length of the second housing 220.

According to an embodiment, the coupling shape of the first housing 210 and the second housing 220 is not limited to the shapes and coupling shown in FIGS. 2A, 2B, 2C, and 2D, and may be implemented by a combination and/or coupling of other shapes or components.

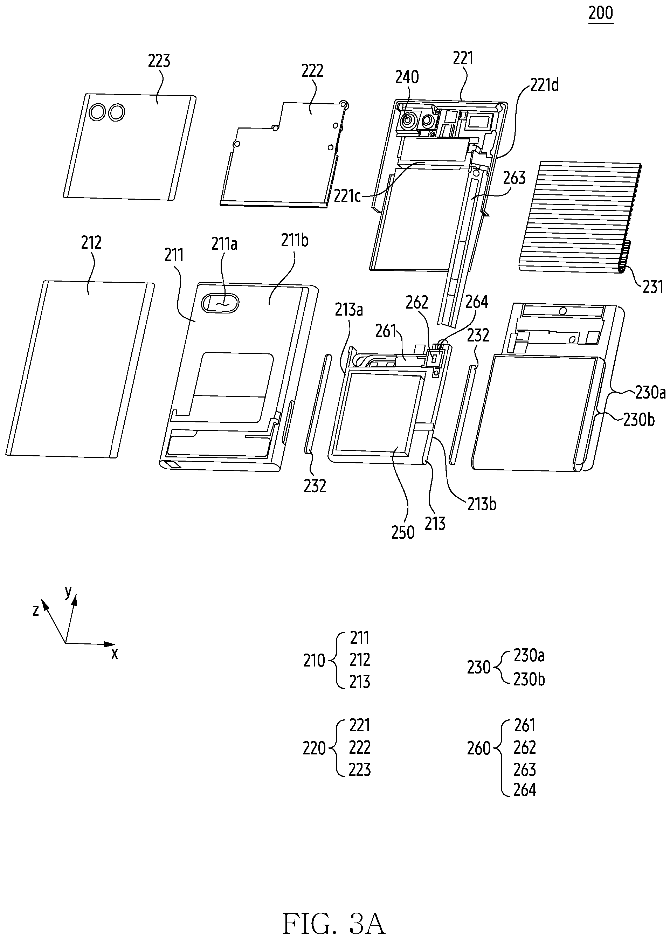

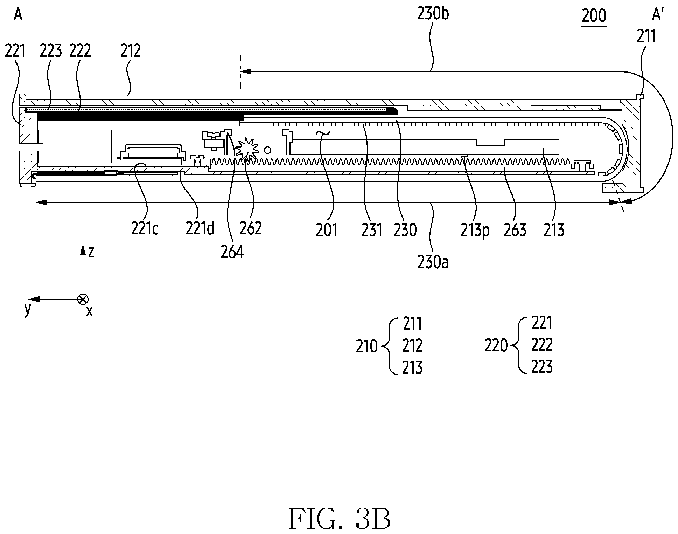

FIG. 3A is an exploded perspective view of an electronic device according to an embodiment, and FIG. 3B is a cross-sectional view illustrating an example in which an electronic device according to an embodiment is cut along A-A' of FIG. 2A.

Referring to FIGS. 3A and 3B, an electronic device 200 according to an embodiment may include a first housing 210, a second housing 220, a display 230, a camera 240, a battery 250 (e.g., the battery 189 of FIG. 1), and a driving portion 260. According to an embodiment, the first housing 210 and the second housing 220 may be coupled to each other to form an inner space 201 of the electronic device 200. For example, in the first state of the electronic device 200, the second region 230b of the display 230 may be accommodated in the inner space 201.

According to an embodiment, the first housing 210 may include a book cover 211, a rear plate 212, and a frame cover 213. According to an embodiment, the book cover 211, the rear plate 212, and the frame cover 213 included in the first housing 210 may be coupled to each other and may not move with the second housing 220 when the second housing 220 moves with respect to the first housing 210.

According to an embodiment, the book cover 211 may form at least a part of an outer surface of the electronic device 200. For example, the book cover 211 may form at least a part of the side surface of the electronic device 200 and at least a part of the rear surface of the electronic device 200. According to an embodiment, the book cover 211 may provide a surface on which the rear plate 212 is seated. The rear plate 212 may be seated on one surface 211b of the book cover 211.

According to an embodiment, the frame cover 213 may support internal components of the electronic device 200. For example, the frame cover 213 may accommodate at least a part of the battery 250 and the driving portion 260. The battery 250 and the driving portion 260 may be accommodated in at least one of a recess or a hole included in the frame cover 213. According to an embodiment, the frame cover 213 may be surrounded by the book cover 211. For example, in the first state of the electronic device 200, a surface 213a of the frame cover 213 on which the battery 250 is disposed may face the book cover 211 and/or the second region 230b of the display 230. For another example, in the first state of the electronic device 200, another surface 213b of the frame cover 213 facing the one surface 213a of the frame cover 213 may face the first region 230a of the display 230 or the front cover 221. For example, the frame cover 213 may include aluminum as a material, but is not limited thereto.

According to an embodiment, the second housing 220 may include the front cover 221, a rear cover 222, and a slide cover 223. According to an embodiment, the front cover 221, the rear cover 222, and the slide cover 223 are coupled to each other and may move together with the second housing 220 when the second housing 220 moves relative to the first housing 210. The front cover 221 may support internal components of the electronic device 200. For example, the camera 240 may be disposed on one surface 221c of the front cover 221 facing the inner space 201. Another surface 221d of the front cover 221 facing the one surface 221c of the front cover 221 may face the first region 230a of the display 230 when the electronic device 200 is in the first state. According to an embodiment, the rear cover 222 may be coupled to the front cover 221 to protect components of the electronic device 200 disposed on the front cover 221. For example, the rear cover 222 may cover at least a part of one surface 221c of the front cover 221. According to an embodiment, the slide cover 223 may be disposed on the rear cover 222 (e.g., in the +z direction) to form an outer surface of the electronic device 200 together with the rear plate 212 and the book cover 211. The slide cover 223 may be coupled to one surface of the rear cover 222 to protect the rear cover 222 and/or the front cover 221.

According to an embodiment, when the electronic device 200 is in the first state, the display 230 may be bent by at least partially being rolled into the inner space 201. According to an embodiment, the display 230 may cover at least a part of the frame cover 213 and at least a part of the front cover 221. For example, when the electronic device 200 is in the first state, the display 230 may cover the other surface 221d of the front cover 221, and extend toward the inner space 201 by passing between the front cover 221 and the book cover 211. When the electronic device 200 is in the first state, the display 230 may pass between the front cover 221 and the book cover 211, and thus surround the frame cover 213 disposed in the inner space 201. The display 230 may cover one surface 213a of the frame cover 213 in the inner space 201. According to an embodiment, when the second housing 220 moves in the first direction, the second region 230b of the display 230 may be pulled out from the inner space 201. For example, as the second housing 220 moves in the first direction, the display 230 may pass between the front cover 221 and the book cover 211, and thus be pulled out from the inner space 201.

According to an embodiment, the first region 230a of the display 230 may be in contact with the other surface 221d of the front cover 221. For example, the first region 230a may extend parallel to the other surface 221d of the front cover 221 while contacting the other surface 221d of the front cover 221. The first region 230a may extend in parallel to the other surface 221d of the front cover 221, and thus may have a substantially plane shape. According to an embodiment, the first region 230a of the display 230 may not be deformed according to the movement of the second housing 220. For example, the first region 230a may move as the second housing 220 moves while maintaining the shape of a plane surface.

According to an embodiment, the second region 230b of the display 230 may be deformed according to the movement of the second housing 220. For example, when the electronic device 200 is in the first state, the second region 230b may be bent with a curvature in the inner space 201 of the electronic device 200. When the second housing 220 moves in the first direction (e.g., the +y direction), at least a part of the second region 230b may be pulled out from the inner space 201 of the electronic device 200 and may be parallel to the other surface 221d of the front cover 221. When at least a part of the second region 230b is parallel to the other surface 221d of the front cover 221, at least a part of the second region 230b may not have a curvature and may have a shape of a plane surface. For another example, when the second housing 220 moves in the second direction (e.g., the -y direction), at least a part of the second region 230b may be inserted into the inner space 201 of the electronic device 200. At least a part of the second region 230b may be bent to have a curvature while being inserted into the inner space 201 of the electronic device 200.

According to an embodiment, the second region 230b of the display 230 may be deformed according to the movement of the second housing 220. For example, when the electronic device 200 is in the first state, the second region 230b may be bent with a curvature in the inner space 201 of the electronic device 200. When the second housing 220 moves in the first direction (e.g., the +y direction), at least a part of the second region 230b may be pulled out from the inner space 201 of the electronic device 200 and may be parallel to the other surface 221d of the front cover 221. When at least a part of the second region 230b is parallel to the other surface 221d of the front cover 221, at least a part of the second region 230b may not have a curvature and may have a shape of a plane surface. For another example, when the second housing 220 moves in the second direction (e.g., the -y direction), at least a part of the second region 230b may be inserted into the inner space 201 of the electronic device 200. At least a part of the second region 230b may be bent to have a curvature while being inserted into the inner space 201 of the electronic device 200.

According to an embodiment, a guide rail 232 may guide the movement of a guiding member 231. For example, as the display 230 moves, the guiding member 231 may move along the guide rail 232 coupled to the frame cover 213. According to an embodiment, the guide rail 232 may include a plurality of guide rails 232 disposed to be spaced apart from each other at both peripheries of the frame cover 213 spaced apart from each other in a third direction perpendicular to the first direction (e.g., the +x direction).

According to an embodiment, the driving portion 260 may provide a driving force to the second housing 220 so that the second housing 220 may move relative to the first housing 210. According to an embodiment, the driving portion 260 may include a motor 261, a pinion gear 262, a rack gear 263, and a bracket 264. The motor 261 may receive power from the battery 250 and provide a driving force to the second housing 220. According to an embodiment, the motor 261 may be disposed in the first housing 210 and may not move together with the second housing 220 when the second housing 220 moves with respect to the first housing 210. For example, the motor 261 may be disposed in a recess formed in the frame cover 213. According to an embodiment, the pinion gear 262 may be coupled to the motor 261 and may be rotated by a driving force provided from the motor 261. According to an embodiment, the rack gear 263 may engage with the pinion gear 262 and may move according to rotation of the pinion gear 262. For example, the rack gear 263 may reciprocate linearly in the first direction or the second direction according to the rotation of the pinion gear 262. According to an embodiment, the rack gear 263 may be disposed in the second housing 220. For example, the rack gear 263 may be coupled to the front cover 221 included in the second housing 220. According to an embodiment, the rack gear 263 may be movable inside the operating space 213p formed in the frame cover 213. According to an embodiment, the bracket 264 may maintain the position of the pinion gear 262 so that the driving force of the motor 261 may be smoothly transmitted to the rack gear 263.

According to an embodiment, when the pinion gear 262 rotates in the first rotation direction (e.g., clockwise in FIG. 3B), the rack gear 263 may move in the first direction (e.g., the +y direction). When the rack gear 263 moves in the first direction, the second housing 220 coupled to the rack gear 263 may move in the first direction. When the pinion gear 262 rotates in a second rotation direction (e.g., counterclockwise in FIG. 3B), the rack gear 263 may move in a second direction (e.g., the -y direction). When the rack gear 263 moves in the second direction, the second housing 220 coupled to the rack gear 263 may move in the second direction. As the second housing 220 moves in the second direction, the area of the display 230 visible from the outside of the electronic device 200 may be contracted.

In the above description, it has been described that the motor 261 and the pinion gear 262 are disposed in the first housing 210, and the rack gear 263 is disposed with the second housing 220, but embodiments are not limited thereto. According to embodiments, the motor 261 and the pinion gear 262 may be disposed in the second housing 220, and the rack gear 263 may be disposed in the first housing 210.

For example, the first housing 210 and the display 230 may be spaced apart from each other so that the display 230 may move with respect to the first housing 210. A foreign material may be flowed from the outside of the electronic device 200 to the inside of the electronic device 200 through a gap between the first housing 210 and the display 230. The foreign material flowed through the gap may be positioned between the first housing 210 and the display 230 to damage the display 230, and may be flowed into the inner space 201 of the electronic device 200, thereby damaging the internal components of the electronic device 200. Hereinafter, the electronic device 200 including a structure for preventing inflow of a foreign material between the first housing 210 and the display 230 will be described in detail.

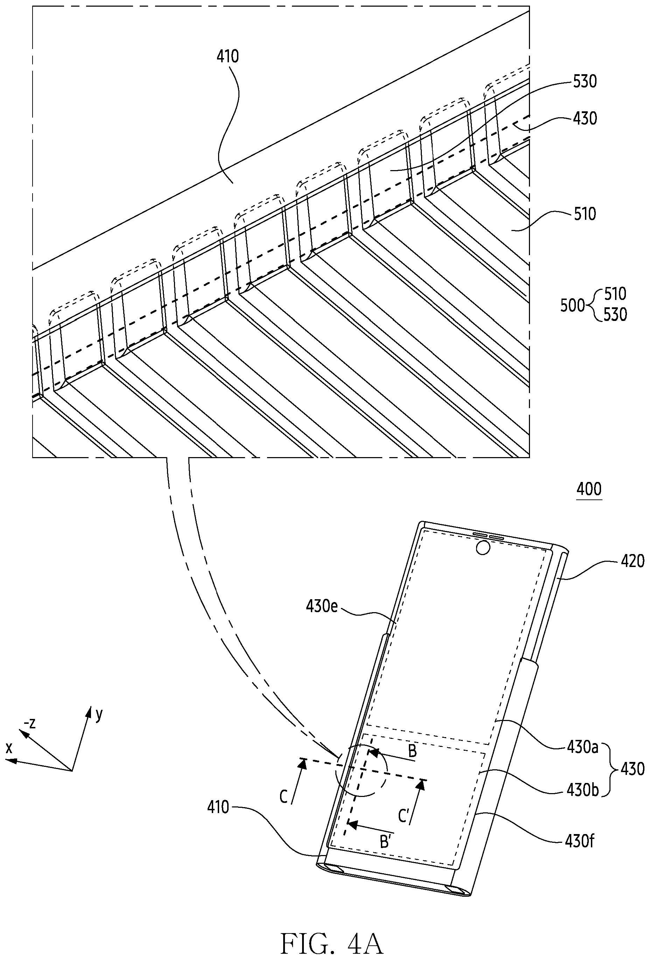

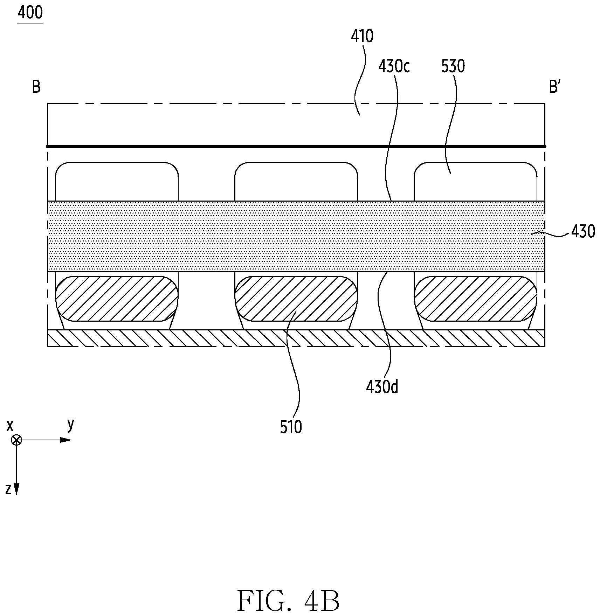

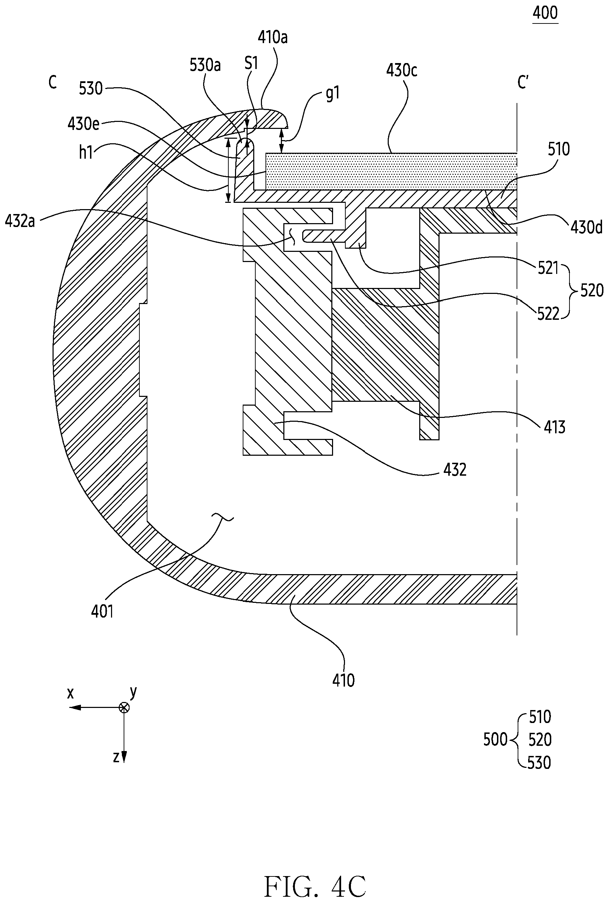

FIG. 4A is a perspective view of a second state of an electronic device according to an embodiment, FIG. 4B is a cross-sectional view illustrating an example in which an electronic device according to an embodiment is cut along B-B' of FIG. 4A, and FIG. 4C is a cross-sectional view illustrating an example in which an electronic device according to an embodiment is cut along C-C' of FIG. 4A.

Referring to FIGS. 4A, 4B, and 4C, the electronic device 400 according to an embodiment (e.g., the electronic device 101 of FIG. 1 and/or the electronic device 200 of FIGS. 3A and 3B) may include a first housing 410, a second housing 420, a display 430, a guide rail 432, and/or a guiding member 500. The first housing 410, the second housing 420, the display 430, the guide rail 432, and the guiding member 500 of FIGS. 4A and 4B may be substantially the same as the first housing 210, the second housing 220, the display 230, the guide rail 232 and/or the guide member 231 of FIGS. 3A and 3B, respectively, and thus repeated descriptions thereof will be omitted.

According to an embodiment, the first housing 410 may form at least a part of an outer surface of the electronic device 400 gripped by a user. The first housing 410 may surround at least a part of the second housing 420. For example, the second housing 420 may be coupled to the first housing 410 so that at least a part thereof may be inserted into the first housing 410 or may be pulled out from the first housing 410.

According to an embodiment, the second housing 420 may be coupled to the first housing 410 to be slidable with respect to the first housing 410. For example, the second housing 420 may be movable in a first direction (e.g., in the +y direction) or a second direction (e.g., in the -y direction) opposite to the first direction with respect to the first housing 410. The first direction may be a direction in which the area of the display 430 viewable from the outside of the electronic device 400 is expanded according to the movement of the second housing 420. The second direction may be a direction in which the area of the display 430 viewable from the outside of the electronic device 400 is contracted according to the movement of the second housing 420.

According to an embodiment, the state of the electronic device 400 may include a first state in which the second housing 420 may move in the first direction among the first direction and the second direction, and a second state in which the second housing 420 may move in the second direction among the first direction and the second direction. For example, when the electronic device 400 is in the first state, the second housing 420 may only be movable in the first direction and may not be movable in the second direction. For another example, when the electronic device 400 is in the second state, the second housing 420 may only be movable in the second direction and may not be movable in the first direction.

According to an embodiment, the display 430 may be disposed in the second housing 420 and may move together with the second housing 420 according to the movement of the second housing 420. For example, the display 430 may include a first region 430a disposed on one surface of the second housing 420 and a second region 430b deformable by the movement of the second housing 420. The first region 430a and the second region 430b of FIGS. 4A and 4B may be substantially the same as the first region 230a and the second region 230b of FIGS. 3A and 3B, respectively, and thus a repeated description thereof will be omitted. According to an embodiment, the display 430 may be contracted according to the slide-in of the second housing 420 with respect to the first housing 410. The contracting of the display 430 may mean that the size of the area of the display 430 visible from the outside of the electronic device 400 is reduced. For example, at least a part of the second housing 420 may be inserted into the first housing 410 according to the slide-in of the second housing 420 with respect to the first housing 410. As at least a part of the second housing 420 is inserted into the first housing 410, the display 430 disposed in the second housing 420 may be inserted into the first housing 410. According to an embodiment, the display 430 may be extended according to the slide-out of the second housing 420 with respect to the first housing 410. The expanding of the display 430 may mean that the size of the area of the display 430 visible from the outside of the electronic device 400 is increased. For example, at least a part of the second housing 420 may be pulled out to the outside of the first housing 410 according to the slide-out of the second housing 420 with respect to the first housing 410. As at least a part of the second housing 420 is pulled out to the outside of the first housing 410, the display 430 disposed in the second housing 420 may be pulled out to the outside of the first housing 410.

According to an embodiment, the first region 430a may be fixedly visible from outside of the electronic device 400 regardless of whether the electronic device 400 is in a first state or a second state. For example, the first region 430a may substantially maintain the shape of a plane surface on one surface of the second housing 420 regardless of the movement of the second housing 420.

According to an embodiment, the second region 430b may be pulled out from the inner space 401 of the electronic device 400 or may be inserted into the inner space 401 by movement of the second housing. For example, when the electronic device 400 is in the first state, the second region 430b may be disposed in the inner space 401 (e.g., the inner space 201 of FIG. 3B) of the electronic device 400 in a state where at least a part is bent. As the second housing 420 moves in the first direction (e.g., the +y direction), the second region 430b may be pulled out from the inner space 401 of the electronic device 400. For example, at least a part of the second region 430b pulled out from the inner space 401 may have a shape substantially the same plane surface as the first region 430a. At least a part of the second region 430b pulled-out from the inner space 401 may be visible from the outside of the electronic device 400. As the second housing 420 moves in the second direction (e.g., the -y direction), the second region 430b may be inserted into the inner space 401 of the electronic device 400. For example, at least a part of the second region 430b inserted into the inner space 401 may be bent with respect to the first region 430a to have a curvature. At least a part of the second region 430b inserted into the inner space 401 may not be visible from the outside of the electronic device 400.

According to an embodiment, the display 430 may include a first surface 430c facing the outside of the electronic device 400, a second surface 430d facing the inner space 401 of the electronic device 400, and a first side surface 430e and a second side surface 430f that are parallel to the moving direction of the display 430 and face each other. According to an embodiment, the first surface 430c may form at least a part of the front surface of the electronic device 400. The display 430 may display visual information to the user through the first surface 430c. The second surface 430d may face the first surface 430c and may not be visible from the outside of the electronic device 400. For example, the second surface 430d may be arranged in parallel to the first surface 430c The second surface 430d may face the inner space 401 of the electronic device 400. The first side surface 430e and the second side surface 430f may be perpendicular to the first surface 430c and the second surface 430d. For example, the first side surface 430e may face a third direction (e.g., the +x direction) perpendicular to the first direction and may be perpendicular to the first surface 430c and the second surface 430d. For another example, the second side surface 430f may face the first side surface 430e, and face the fourth direction (e.g., the -x direction) opposite to the third direction. For example, the second side surface 430f may be arranged in parallel to the first side surface 430e.

According to an embodiment, the first housing 410 may include a frame cover 413 facing at least a part of the display 430. Since the frame cover 413 of FIG. 4C may be substantially the same as the frame cover 213 of FIGS. 3A and 3B, a repeated description will be omitted. The frame cover 413 may face the second surface 430d of the display 430. For example, the longest side of the frame cover 413 may face the second surface 430d of the display 430.

According to an embodiment, the guide rail 432 may be disposed in the first housing 410. The guide rail 432 may guide the movement of the guiding member 500. According to an embodiment, the guide rail 432 may include a guide path 432a (see FIG. 4C) for guiding movement of each of a plurality of supporting bars 510 of the guiding member 500. According to an embodiment, the guide rail 432 may be disposed at one periphery of the frame cover 413 facing a third direction (e.g., +x direction) perpendicular to the first direction (e.g., the +y direction), which is the moving direction of the second housing 420. The one periphery of the frame cover 413 may be arranged in parallel to the first side surface 430e of the display 430. According to an embodiment, the guide rail 432 may be disposed at another periphery of the frame cover 413 facing a fourth direction (e.g., the -x direction) opposite to the third direction, which is the moving direction of the second housing 420. The other periphery of the frame cover 413 may be arranged in parallel to the second side surface 430f of the display 430. For example, the guide rail 432 may be coupled, in particular mechanically or adhesively coupled, to the frame cover 413 through a coupling member (e.g., screw or adhesive) (not shown), but is not limited thereto.

According to an embodiment, the guiding member 500 may support the second region 430b of the display 430. According to an embodiment, the guiding member 500 may include a plurality of supporting bars 510, a plurality of guiding protrusions 520, and a plurality of barriers 530.

According to an embodiment, each of the plurality of supporting bars 510 may support the second region 430b of the display 430. For example, each of the plurality of supporting bars 510 may be disposed in the second region 430b of the display 430 and may be spaced apart from each other. Each of the plurality of supporting bars 510 may be in (direct) contact with the second surface 430d of the display 430. Each of the plurality of supporting bars 510 in contact with the second surface 430d may not be visible from the outside of the electronic device 400. For example, the plurality of supporting bars 510 may extend on the second surface 430d of the display 430 in a third direction (e.g., +x direction) or a fourth direction (e.g., -x direction) parallel to the second surface 430d of the display 430. For another example, the plurality of supporting bars 510 may be extended in a direction from the first side surface 430e of the display 430 to the second side surface 430f, but is not limited to the above-described examples. In other words, a length of the plurality of supporting bars 510 in a direction from the first side surface 430e of the display 430 to the second side surface 430f is equal to or longer than a length of the display between the first side surface 430e and the second side surface 430f. According to an embodiment, the plurality of supporting bars 510 may be movable together with the display 430 according to the movement of the display 430. For example, the plurality of supporting bars 510 may be disposed on, in particular directly on, the second surface 430d of the display 430 by an adhesive member having adhesive force, but are not limited thereto.

According to an embodiment, the plurality of supporting bars 510 may have a shape corresponding to the shape of the second region 430b. For example, when the electronic device 400 is in the first state, the plurality of supporting bars 510 may have a shape corresponding to the shape of the second region 430b of the display 430 bent in the inner space 401 of the electronic device 400. For another example, when the electronic device 400 is in the second state, the plurality of supporting bars 510 may have a shape corresponding to at least a part of the second region 430b having a substantially plane surface shape. According to an embodiment, the plurality of supporting bars 510 may be arranged to correspond to the shape of the second region 430b. For example, each of the plurality of supporting bars 510 may support the second surface 430d of the display 430 while being spaced apart from each other. As the shape of the second region 430b is changed by the movement of the second housing 420 with respect to the first housing 410, the plurality of supporting bars 510 spaced apart from each other may be arranged to correspond to the shape of the second region 430b. For example, in a case that the second region 430b is deformed so as not to have a curvature, each of the plurality of supporting bars 510 may be arranged parallel to each other. For another example, in a case that the shape of the second region 430b is deformed to have a curvature, each of the plurality of supporting bars 510 may be arranged to be inclined with respect to each other.

The plurality of guiding protrusions 520 may guide movement of the plurality of supporting bars 510. According to an embodiment, each of the plurality of guiding protrusions 520 may be disposed in the plurality of supporting bars 510. For example, the plurality of guiding protrusions 520 may be extended from the other surface of each of the plurality of supporting bars 510 facing each of one surface of the plurality of supporting bars 510 contacting the second surface 430d. According to an embodiment, the plurality of guiding protrusions 520 may be movable together with the plurality of supporting bars 510 according to the movement of the display 430. For example, each of the plurality of guiding protrusions 520 may be movable within the guide path 432a of the guide rail 432 according to the movement of the display 430. In an embodiment, the guiding protrusions 520 may be integrally formed with the supporting bars 510.

According to an embodiment, each of the plurality of guiding protrusions 520 may include a connecting portion 521 extended from each of the plurality of supporting bars 510 and a protruding portion 522 extended substantially perpendicular with respect to the connecting portion 521. According to an embodiment, the connecting portion 521 may be extended or may protrude in a direction (e.g., the -z direction) from the first surface 430c of the display 430 to the second surface 430d. For example, the connecting portion 521 may be extended from the other surface of each of the plurality of supporting bars 510. The other surface of each of the plurality of supporting bars 510 may be opposite to one surface of each of the plurality of supporting bars 510 contacting the second surface 430d. According to an embodiment, the protruding portion 522 may be connected substantially perpendicular to the connecting portion 521, and at least a part may be inserted into the guide path 432a. For example, the protruding portion 522 may be extended or may protrude from connecting portion 521 in a third direction (e.g., +x direction) or a fourth direction (e.g., -x direction) parallel to the second surface 430d of the display 430.

According to an embodiment, each of the plurality of barriers 530 may be extended or may protrude from at least one of both ends of each of the plurality of supporting bars 510. For example, each of the plurality of barriers 530 may be disposed on at least one of one end of each of the plurality of supporting bars 510 close to the first side surface 430e among the first side surface 430e and the second side surface 430f of the display 430, or the other end of each of the plurality of supporting bars 510 close to the second side surface 430f among the first side surface 430e and the second side surface 430f. According to an embodiment, the number of the plurality of barriers 530 may correspond to the number of both ends of each of the plurality of supporting bars 510, but is not limited thereto. For example, according to embodiments, the number of the plurality of barriers 530 may correspond only to the number of one end of each of the plurality of supporting bars 510. For another example, the number of the plurality of barriers 530 may exceed the number of both ends of each of the plurality of supporting bars 510.

According to an embodiment, each of the plurality of barriers 530 may be extended in a direction substantially perpendicular to the second surface 430d of the display 430. For example, each of the plurality of barriers 530 may be extended in a direction (e.g., the -z direction) from the second surface 430d of the display 430 to the first surface 430c of the display 430. According to an embodiment, each of the plurality of barriers 530 may be movable together with the plurality of supporting bars 510 according to the movement of the display 430. For example, when the electronic device 400 is in the first state, the plurality of barriers 530 may be disposed in the inner space 401 of the electronic device 400. For another example, at least a part of the plurality of barriers 530 may be disposed on the front surface of the electronic device 400 when the electronic device 400 is in the second state. According to an embodiment, the extension direction of the plurality of barriers 530 may be opposite to the extension direction of the plurality of guiding protrusions 520. For example, each of the plurality of barriers 530 may be extended from the plurality of supporting bars 510 in a direction (e.g., the -z direction) from the second surface 430d to the first surface 430c. Each of the plurality of guiding protrusions 520 may be extended from the plurality of supporting bars 510 in a direction (e.g., the +z direction) from the first surface 430c opposite to the extension direction of the plurality of barriers 530 to the second surface 430d.

According to an embodiment, each of the plurality of barriers 530 may face the first side surface 430e or the second side surface 430f of the display 430. Each of the plurality of barriers 530 facing the first side surface 430e or the second side surface 430f may prevent an inflow of foreign materials into the inner space 401 of the electronic device 400. For example, when the electronic device 400 is in the second state, each of the plurality of barriers 530 may be disposed between the first housing 410 and the first side surface 430e of the display 430 or between the first housing 410 and the second side surface 430f of the display 430. For another example, each of the plurality of barriers 530 may overlap a part of the first housing 410 when the display 430 is viewed from above (e.g., the -z direction). The plurality of barriers 530 may block entry of foreign materials through the gap g1 between the first housing 410 and the display 430. For example, a gap g1 may be formed between the first housing 410 and the first side surface 430e of the display 430 or between the first housing 410 and the second side surface 430f so that the display 430 may move by the movement of the second housing 420. In the absence of a plurality of barriers 530, the foreign materials may flow through the gap g1 between the first housing 410 and the first side surface 430e or between the first housing 410 and the second side surface 430f. The foreign materials may be located in the gap g1 between the first housing 410 and the first side surface 430e or the first housing 410 and the second side surface 430f to damage the display 430, or may move to the inner space 401 to damage internal components of the electronic device 400. When a separate component (or structure) is added to a portion 410a of the first housing 410 adjacent to the display 430 to prevent the entry of the foreign materials, at least a part 410a of the first housing 410 may be extended in a direction (e.g., the -x direction) toward the display 430 so that a separate component (or structure) may be disposed. Since at least a part 410a of the first housing 410 covers at least a part of the first surface 430c of the display 430 when at least a part 410a of the first housing 410 extends toward the display 430, the visible region of the display 430 may be decreased. The electronic device 400 according to an embodiment may provide a structure that prevents the foreign materials from flowing through the gap g1 between the first housing 410 and the display 430 by the plurality of barriers 530 disposed in the plurality of supporting bars 510 supporting the second region 430b of the display 430. The electronic device 400 according to an embodiment may provide a structure that prevents inflow of the foreign materials and prevents a decrease in the visible area of the display 430 by the plurality of barriers 530 facing the side surfaces 430e and 430f of the display 430.

According to an embodiment, the plurality of barriers 530 may be spaced apart from each other. For example, the plurality of barriers 530 may be spaced apart from each other along the moving direction of the display 430. Since the plurality of supporting bars 510 may not have a shape corresponding to the second region 430b when a plurality of barriers 530 are connected to each other, the display 430 may not move smoothly. The electronic device 400 according to an embodiment may provide a structure that may smoothly move the display 430 by the plurality of barriers 530 disposed in each of the plurality of supporting bars 510 spaced apart from each other.

According to an embodiment, a height h1 of each of the plurality of barriers 530 may be longer than a thickness t1 of the display 430. For example, the height h1 of each of the plurality of barriers 530 and the thickness t1 of the display 430 may mean a length in a direction (e.g., -z direction) from the second surface 430d to the first surface 430c, respectively. For example, one end 530a of each of the plurality of barriers 530 may be disposed between the first surface 430c of the display 430 and the first housing 410. According to an embodiment, one end 530a of each of the plurality of barriers 530 may be spaced apart from the first housing 410 so that the display 430 may move smoothly. For example, the size of the space s1 between one end 530a of each of a plurality of barriers 530 and the first housing 410 may be smaller than the gap g1 between the first housing 410 and the first surface 430c of the display 430. When the height h1 of each of the plurality of barriers 530 is less than the thickness t1 of the display 430 the plurality of barriers 530 may not block the foreign materials entering through the gap g1. The electronic device 400 according to an embodiment may block inflow of the foreign materials through the gap g1 between the first housing 410 and the display 430 by the plurality of barriers 530 having a height h1 longer than the thickness t1 of the display 430.

As described above, according to an embodiment, the electronic device 400 may provide a structure for preventing inflow of the foreign materials through the gap g1 between the first housing 410 and the display 430 by the plurality of barriers 530 disposed on each of the plurality of supporting bars 510 supporting the second region 430b of the display 430. The electronic device 400 according to an embodiment may provide a structure capable of expanding the visible area of the display 430 while preventing the inflow of the foreign materials by the plurality of barriers 530 facing the side surfaces 430e and 430f of the display 430. The electronic device 400 according to an embodiment may provide a structure capable of moving smoothly the display by the plurality of barriers 530 disposed to be spaced apart from each other.

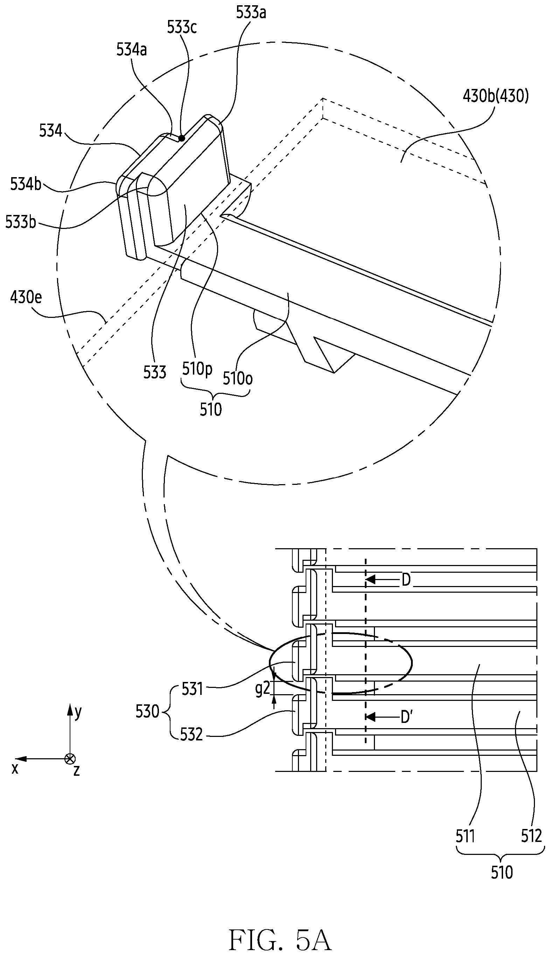

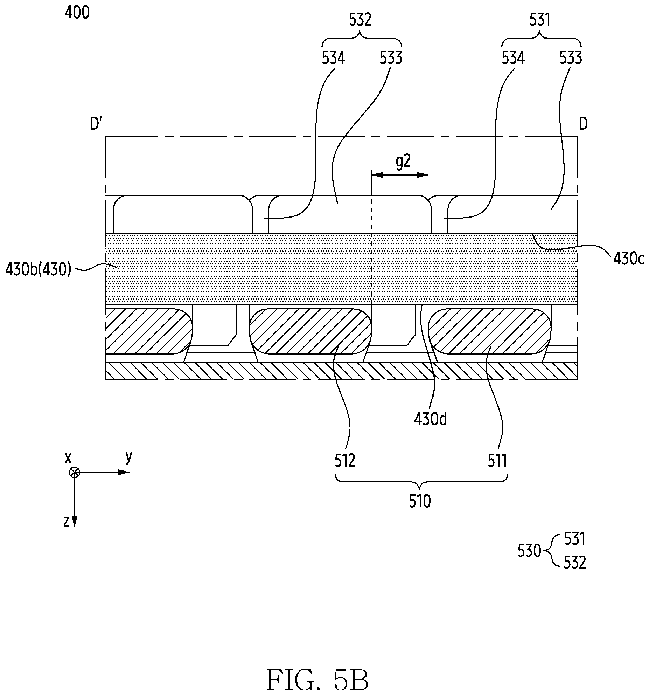

FIG. 5A is a front view of a guiding member and a display of an electronic device according to an embodiment, and FIG. 5B is a cross-sectional view illustrating an example in which a guiding member and a display of an electronic device according to an embodiment are cut along D-D' of FIG. 5A.

Referring to FIG. 5A and FIG. 5B, according to an embodiment, a plurality of supporting bars 510 may include a first supporting bar 511, and a second supporting bar 512 spaced apart from the first supporting bar 511 along the moving direction of the display 430. The first supporting bar 511 and the second supporting bar 512 may be extended on the second surface 430d of the display 430. For example, the first supporting bar 511 and the second supporting bar 512 may be extended on the second surface 430d in a direction perpendicular to the moving direction of the display 430.

According to an embodiment, a plurality of barriers 530 may include a first barrier 531 and a second barrier 532 disposed at one end of each of the plurality of supporting bars 510. For example, the first barrier 531 may be extended from at least one of both ends of the first supporting bar 511 in a direction (e.g., the -z direction or the +z direction) perpendicular to the second surface 430d of the display 430. For another example, the second barrier 532 may be extended from at least one of both ends of the second supporting bar 512 in a direction (e.g., the -z direction or the +z direction) perpendicular to the second surface 430d of the display 430. The first barrier 531 and the second barrier 532 may be spaced apart from each other along the moving direction of the display 430.

According to an embodiment, the shapes of the plurality of barriers 530 may be substantially the same as each other. For example, each of the first barrier 531 and the second barrier 532 may include a first extending portion 533 facing the second region 430b of the display 430, and a second extending portion 534 connected to a part of the first extending portion 533 facing the outside of the first extending portion 533. A direction toward the outside of the first extending portion 533 may mean a direction opposite to a direction toward the display 430 (e.g., the -x direction). According to an embodiment, the first extending portion 533 may be extended or may protrude in a direction (e.g., the +y direction) parallel to the moving direction of the display 430. The first extending portion 533 may face the first side surface 430e of the display 430. According to an embodiment, the second extending portion 534 may be extended or may protrude along the moving direction of the display 430 from one point of the first extending portion 533 facing a direction (e.g., the +x direction) away from the second region 430b. For example, the second extending portion 534 may be extended or may protrude from the first point 533c of the first extending portion 533 spaced apart from both ends 533a and 533b of the first extending portion 533 among the points of the first extending portion 533. As the second extending portion 534 extends from the first point 533c, both ends 534a and 534b of the second extending portion 534 may be spaced apart from both ends 533a and 533b of the first extending portion 533, respectively. For example, a length of the second extending portion 534 extending in the moving direction of the display 430 may correspond to a length of the first extending portion 533 extending in the moving direction of the display 430. The first extending portion 533 and the second extending portion 534 may be aligned offset to one another in the moving direction. For another example, the length of the second extending portion 534 extending in the moving direction of the display 430 may not correspond to the length of the first extending portion 533 extending in the moving direction of the display 430. The length of the second extending portion 534 may be longer or shorter than the length of the first extending portion 533.

According to an embodiment, the plurality of barriers 530 may overlap each other when the display 430 is viewed from the first side surface 430e (e.g., in the -x direction). At least a part of the first barrier 531 may overlap at least a part of the second barrier 532. For example, at least a part of the second extending portion 534 of the first barrier 531 may overlap at least a part of the first extending portion 533 of the second barrier 532. Since the plurality of barriers 530 overlap each other, the inflow of the foreign materials through the gap g2 formed between the plurality of barriers 530 along the moving direction of the display 430 may be reduced. The size of the gap g2 may correspond to an interval between the first supporting bar 511 and the second supporting bar 512. For example, since the plurality of supporting bars 510 may not have a shape corresponding to the second region 430b in a case that a plurality of barriers 530 are connected to each other, the plurality of barriers 530 may be spaced apart from each other. As the plurality of barriers 530 are spaced apart from each other, a gap g2 may be formed between the plurality of barriers 530. When the plurality of barriers 530 do not overlap each other, foreign materials may flow through the gap g2. The electronic device 400 according to an embodiment may reduce the inflow of foreign material through the gap g2 between the plurality of barriers 530 by a plurality of barriers 530 overlapping each other. For example, the second extending portion 534 of the first barrier 531 or the first extending portion 533 of the second barrier 532 may protect the display 430 by blocking the inflow of foreign materials flowing through the gap g2.

According to an embodiment, a width of a part 510p of a supporting bar on which the plurality of barriers 530 are disposed may be greater than a width of another part 510o of the supporting bar connected to a part 510p of the supporting bar. The width of the supporting bar may mean, for example, a length in a direction parallel to the moving direction of the display 430 (e.g., the +y direction or the -y direction). The supporting bar may comprise a step-like portion at the part 510p. The supporting bar may be substantially formed as a T-shape at the part 510p.

As described above, according to an embodiment, the electronic device 400 may provide a structure capable of smoothly moving the display 430 while preventing inflow of the foreign materials through the gap g2 between the plurality of barriers 530 by the plurality of barriers 530 overlapping each other when viewed from the first side surface 430e of the display 430. The electronic device 400 according to an embodiment may provide a structure capable of preventing inflow of the foreign materials through the gap g2 between the plurality of barriers 530 by the plurality of barriers 530 having substantially the same shape as each other.

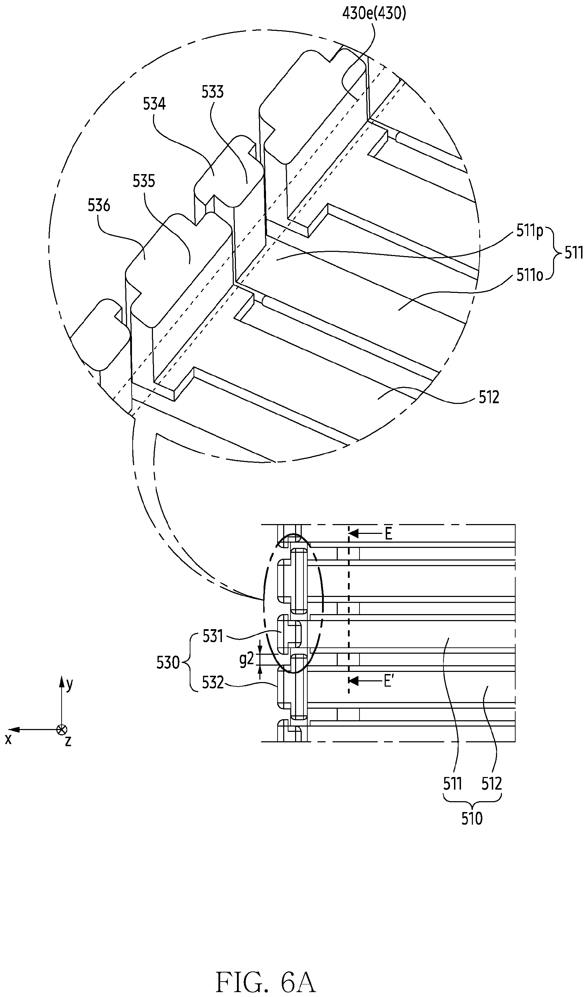

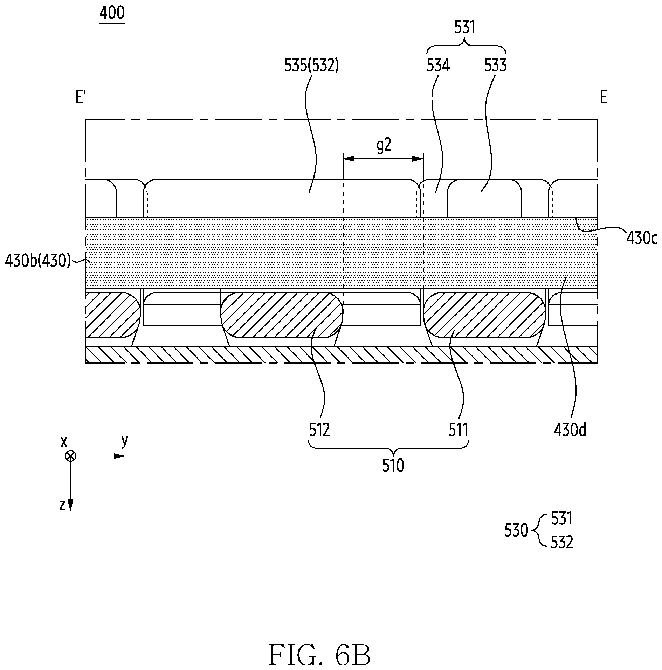

FIG. 6A is a front view of a guiding member and a display of an electronic device according to an embodiment, and FIG. 6B is a cross-sectional view illustrating an example in which a guiding member and a display of an electronic device according to an embodiment are cut along E-E' of FIG. 6A.

Referring to FIGS. 6A and 6B, according to an embodiment, a plurality of supporting bars 510 may include a first supporting bar 511 and a second supporting bar 512 spaced apart from the first supporting bar 511 along the moving direction of the display 430. The first supporting bar 511 and the second supporting bar 512 may be extended on the second surface 430d of the display 430. For example, the first supporting bar 511 and the second supporting bar 512 may be extended on the second surface 430d in a direction perpendicular to the moving direction of the display 430.

According to an embodiment, a plurality of barriers 530 may include a first barrier 531 and a second barrier 532 disposed at one end of each of the plurality of supporting bars 510. For example, the first barrier 531 may be extended from at least one of both ends of the first supporting bar 511 in a direction (e.g., in the -z direction or the +z direction) perpendicular to the second surface 430d of the display 430. For another example, the second barrier 532 may be extended from at least one of both ends of the second supporting bar 512 in a direction (e.g., in the -z direction or the +z direction) perpendicular to the second surface 430d of the display 430. The first barrier 531 and the second barrier 532 may be spaced apart from each other along the moving direction of the display.

According to an embodiment, shapes of the first barrier 531 and the second barrier 532 may be different from each other. For example, the first barrier 531 may include a first extending portion 533 facing the second region 430b and extending in a direction (e.g., the +y direction or the -y direction) parallel to the moving direction of the display 430, and a second extending portion 534 parallel to the first extending portion 533 and extending longer than the first extending portion 533. In other words, the second extending portion 534 may overlap the first extending portion 533 in a direction (e.g., the +y direction or the -y direction) parallel to the moving direction of the display 430. For example, the first barrier 531 may include a step-like portion for separating the first extending portion 533 from the second extending portion 534. The second extending portion 534 may be in contact with a part of the first extending portion 533 facing the outside of the first extending portion 533, and may be extended in a direction parallel to the moving direction of the display 430. A direction facing the outside of the first extending portion 533 may mean a direction (e.g., the -x direction) opposite to a direction facing the display 430. For another example, the second barrier 532 may include a third extending portion 535 facing the second region 430b and extending in a direction (e.g., in the +y direction or the -y direction) parallel to the moving direction of the display 430, and a fourth extending portion 536 parallel to the third extending portion 535 and extending shorter than the third extending portion 535. In other words, the fourth extending portion 536 may overlap the third extending portion 535 in a direction (e.g., the +y direction or the -y direction) parallel to the moving direction of the display 430. For example, the second barrier 532 may include a step-like portion for separating the third extending portion 535 from the fourth extending portion 536. The fourth extending portion 536 may be in contact with a part of the third extending portion 535 facing the outside of the third extending portion 535, and may be extended in a direction parallel to the moving direction of the display 430. The direction facing the outside of the third extending portion 535 may mean a direction (e.g., the +x direction) opposite to the direction facing the display 430. According to an embodiment, the third extending portion 535 may be extended the longest among the first extending portion 533, the second extending portion 534, the third extending portion 535, and the fourth extending portion 536.

According to an embodiment, the plurality of barriers 530 may overlap each other when the display 430 is viewed from the first side surface 430e (e.g., in the -x direction). At least a part of the first barrier 531 may overlap at least a part of the second barrier 532. For example, at least a part of the second extending portion 534 of the first barrier 531 may overlap at least a part of the third extending portion 535 of the second barrier 532 when the display 430 is viewed from the first side surface 430e (e.g., in the -x direction). As at least a part of the second extending portion 534 and at least a part of the third extending portion 535 overlap each other, the inflow of the foreign materials through the gap g2 formed between the plurality of barriers 530 along the moving direction of the display 430 may be reduced. The size of the gap g2 may correspond to an interval between the first supporting bar 511 and the second supporting bar 512. For example, since the plurality of supporting bars 510 may not have a shape corresponding to the second region 430b when the plurality of barriers 530 are connected to each other, the plurality of barriers 530 may be spaced apart from each other. As the plurality of barriers 530 are spaced apart from each other, the gap g2 may be formed between the plurality of barriers 530. When the plurality of barriers 530 do not overlap each other, the foreign materials may flow through the gap g2. According to an embodiment, the electronic device 400 may provide a structure capable of blocking the inflow of foreign materials flowing through the gap g2 and protecting the display 430 by the second extending portion 534 of the first barrier 531 or the first extending portion 533 of the second barrier 532 overlapping each other.

According to an embodiment, the length of the third extending portion 535 may be longer than the width of each of the plurality of supporting bars 510. The width of the supporting bar 510 may mean a length in a direction (e.g., the +y direction or the -y direction) parallel to the moving direction of the display 430. For example, the length of the third extending portion 535 may be longer than the width of the second supporting bar 512 on which the third extending portion 535 and the fourth extending portion 536 are disposed. For another example, the length of the third extending portion 535 may be longer than the width of the first supporting bar 511 on which the first extending portion 533 and the second extending portion 534 are disposed. According to an embodiment, a width of a part 511p of the first supporting bar 511 facing the third extending portion 535 may be smaller than a width of the other part 511o of the first supporting bar 511 connected to a part 511p of the first supporting bar 511. For example, a part 511p of the first supporting bar 511 facing the third extending portion 535 may form a step with respect to the other portion 511o of the first supporting bar 511.

As described above, according to an embodiment, the electronic device 400 may provide a structure capable of moving smoothly the display 430 while preventing inflow of foreign materials through the gap g2 between the plurality of barriers 530 by the plurality of barriers 530 having different shapes and overlapping each other.

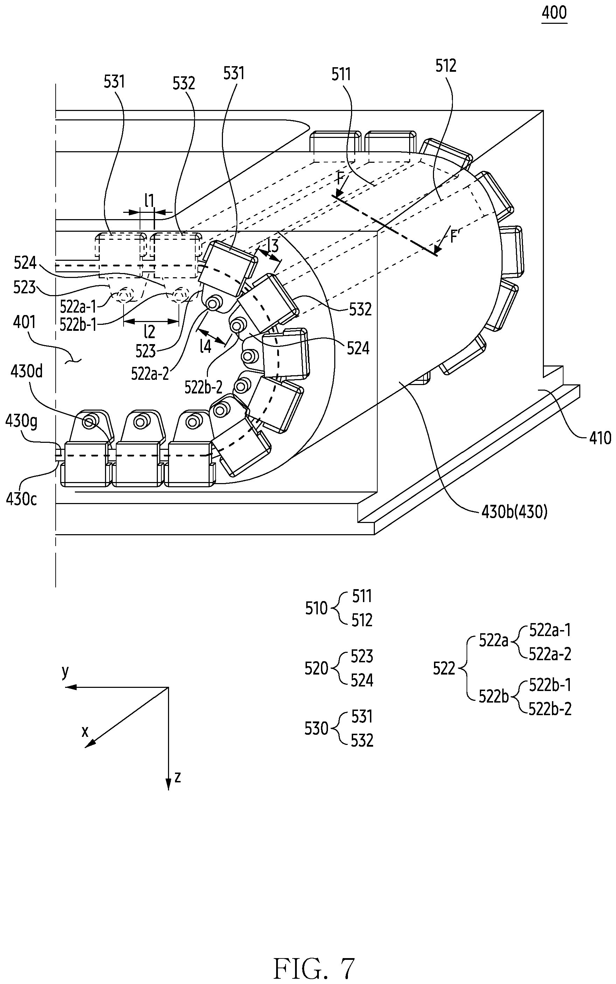

FIG. 7 is an enlarged perspective view illustrating a guiding member and a display of an electronic device according to an embodiment.

Referring to FIG. 7, according to an embodiment, a plurality of supporting bars 510 may include a first supporting bar 511 and a second supporting bar 512 spaced apart from each other along the moving direction of the display 430. For example, the plurality of supporting bars 510 may include the first supporting bar 511 and the second supporting bar 512 spaced apart from the first supporting bar 511 along the moving direction of the display 430. The first supporting bar 511 and the second supporting bar 512 may be extended on the second surface 430d of the display 430. For example, the first supporting bar 511 and the second supporting bar 512 may be extended on the second surface 430d in a direction perpendicular to the moving direction of the display 430.

According to an embodiment, the plurality of guiding protrusion 520 may include a first guiding protrusion 523 and a second guiding protrusion 524 disposed on each of the plurality of supporting bars 510. For example, the plurality of guiding protrusion 520 may include the first guiding protrusion 523 disposed in the first supporting bar 511, and the second guiding protrusion 524 spaced apart from the first guiding protrusion 523 and disposed on the second supporting bar 512. According to an embodiment, the first guiding protrusion 523 and the second guiding protrusion 524 may respectively include a protrusion portion 522. For example, the first guiding protrusion 523 may include a first protruding portion 522a extending in a direction parallel to the first supporting bar 511. For another example, the second guiding protrusion 524 may include a second protruding portion 522b extending in a direction parallel to the second supporting bar 512.

According to an embodiment, the second region 430b of the display 430 may be deformable by the movement of the second housing (e.g., the second housing 420 of FIG. 4A). When the electronic device 400 is in the first state, at least a part of the second region 430b of the display 430 may have a curved surface shape having a curvature in the inner space 401 of the electronic device 400. For example, at least a part of the second region 430b of the display 430 facing the side surface of the first housing 410 facing the second direction (e.g., the -y direction) opposite to the first direction (e.g., the +y direction) may have a curved surface shape. When the electronic device 400 is in the second state, at least a part of the second region 430b may be pulled out from the inner space 401 and may be deformed into a plane surface shape without substantially having a curvature.

According to an embodiment, a tensile force or a compressive force may be generated in at least a part of the second region 430b of the display 430 that is curved to have a curvature. The second region 430b of the display 430 may include a neutral surface 430g in the display 430 defined between the first surface 430c and the second surface 430d. The neutral surface 430g may refer to a boundary between at least a part in the second region 430b where a tensile force is generated and at least a part in the second region 430b where a compressive force is generated. At the boundary, offsetting of the tensile force and the compressive force may occur. For example, when the display 430 is curved, the tensile force may be generated in at least a part of the second region 430b located between the neutral surface 430g and the first surface 430c, and the compressive force may be generated in at least a part of the second region 430b located between the neutral surface 430g and the second surface 430d.

According to an embodiment, when the shape of a part of the display 430 between the plurality of supporting bars 510 is a plane surface, an interval(or gap) between the side surfaces of each of the plurality of barriers 530 facing each other may be smaller than an interval between the plurality of guiding protrusions 520. Hereinafter, the interval may be referred to as a gap. When the shape of a part of the second region 430b between the first supporting bar 511 and the second supporting bar 512 is substantially a plane surface, an interval between the first barrier 531 and the second barrier 532 may be smaller than ab interval between a part of the first guiding protrusions 523 and a part of the second guiding protrusions 524. For example, when a shape of a part of the second region 430b between the first supporting bar 511 and the second supporting bar 512 is substantially a plane surface, the first interval 11 between the side surface of the first barrier 531 and the side surface of the second barrier 532 facing each other may be smaller than the second interval l2 between the first protruding portion 522a-1 which is a part of the first guiding protrusion 523 and the second protruding portion 522b-1 which is a part of the second guiding protrusion 524. According to an embodiment, in a case that the shape of a part of the second region 430b between the first supporting bar 511 and the second supporting bar 512 is substantially deformed from the plane surface to the curved surface, the interval between the first barrier 531 and the second barrier 532 may increase from the first interval 11 to the third interval l3. When in a case that the shape of a part of the second region 430b between the first supporting bar 511 and the second supporting bar 512 is substantially deformed from the plane surface to the curved surface, the interval between the first protruding portion 522a-2 which is part of the first guiding protrusion 523 and the second protruding portion 522b-2 which is part of the second guiding protrusion 524 may be reduced from the second interval l2 to the fourth interval l4. For example, when the shape of a part of the second region 430b is substantially a plane surface, the first interval 11 between the first barrier 531 and the second barrier 532 may be reduced, in order to prevent inflow of the foreign materials. In a state in which the first interval 11 is reduced, when the second interval l2 between a part of the first guiding protrusion523 and a part of the second guiding protrusion524 is not greater than the first interval 11, the display 430 may not move smoothly. For example, as a part of the second region 430b between the first supporting bar 511 and the second supporting bar 512 is bent, when the first interval 11 and the second interval l2 are substantially equal to each other, the first guiding protrusion 523 and the second guiding protrusion 524 may contact each other by compressive force. Since interference occurs when the first guiding protrusion 523 and the second guiding protrusion 524 contact with each other, the display 430 may not move smoothly. According to an embodiment, since the second interval l2 between a part of the first guiding protrusion 523 and a part of the second guiding protrusion524 is greater than the first interval 11 between the first barrier 531 and the second barrier 532, the electronic device 400 may provide a structure in which the display 430 may smoothly move while blocking the inflow of the foreign materials.

As described above, according to an embodiment, since the second interval l2 between guiding protrusions 523 and 524 are greater than the first interval 11 between the barriers 531 and 532 in a case that the second region 430b is substantially in the form of a plane surface, the electronic device 400 may provide a structure in which the display 430 may move smoothly while preventing the inflow of the foreign materials.

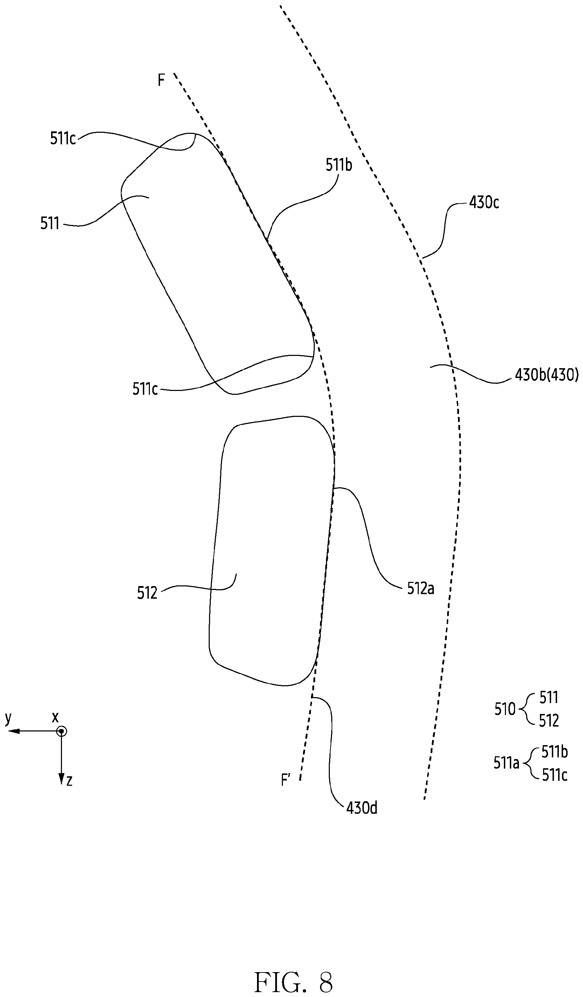

FIG. 8 is a cross-sectional view illustrating an example in which a guiding member and a display of an electronic device according to an embodiment are cut along F-F' of FIG. 7.

Referring to FIG. 8, one surface of each of a plurality of supporting bars 510 according to an embodiment may have a curvature. For example, the plurality of supporting bars 510 may include a first supporting bar 511 and a second supporting bar 512 spaced apart from each other along the moving direction of the display 430. According to an embodiment, one surface 511a of the first supporting bar 511 and one surface 512a of the second supporting bar 512 facing the second surface 430d of the display 430 may have a curvature. For example, one surface 511a of the first supporting bar 511 may include a plane surface 511b in contact with the second surface 430d of the display 430, and a curved surface 511c connected to the plane surface 511b and curved with respect to the plane surface 511b and having a curvature. For example, the curved surface 511c may be arranged at one or both corner areas of the first supporting bar 511 in contact with the second surface 430d of the display 430. For another example, one surface 511a of the first supporting bar 511 may be bent to have a curvature as a whole.

According to an embodiment, as one surface 511a of the first supporting bar 511 and one surface 512a of the second supporting bar 512 have a curvature, the curvature of the second region 430b between the first supporting bar 511 and the second supporting bar 512 may be gradually changed. For example, in a case that one surface 511a of the first supporting bar 511 and one surface 512a of the second supporting bar 512 do not have a curvature, the curvature of the second region 430b between the first supporting bar 511 and the second supporting bar 512 may be rapidly changed between the boundary of the first supporting bar 511 and the boundary of the second supporting bar 512. In a case that the curvature of the second region 430b between the first supporting bar 511 and the second supporting bar 512 changes rapidly, the magnitude of the stress generated in the second region 430b may increase. According to an embodiment, the electronic device 400 may provide a structure for reducing the magnitude of stress generated in the second region 430b of the display 430 by one surface 511a of the first supporting bar 511 and one surface 512a of the second supporting bar 512 having a curvature.

As described above, according to an embodiment, the electronic device 400 may provide a structure for reducing the magnitude of stress generated in the second region 430b by the plurality of supporting bars 510 having a curvature on one surface of the display 430 facing the second surface 430d.

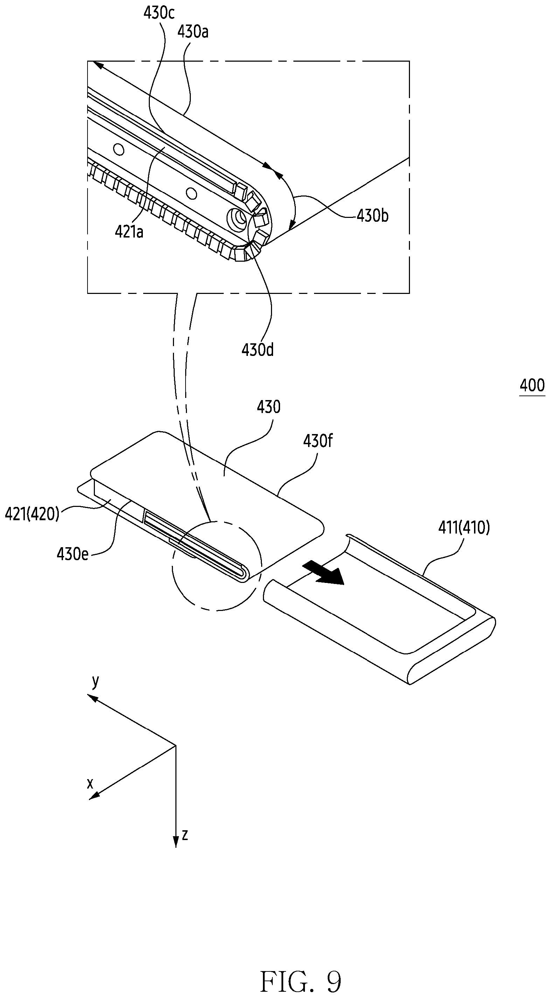

FIG. 9 is a partial exploded perspective view of an electronic device according to an embodiment.

Referring to FIG. 9, according to an embodiment, the first housing 410 may include a book cover 411. The book cover 411 may form at least a part of an outer surface of the electronic device 400 that may be gripped by a user. Since the book cover 411 of FIG. 9 may be substantially the same as the book cover 211 of FIGS. 3A and 3B, a repeated description will be omitted.

According to an embodiment, the second housing 420 may include a front cover 421. Since the front cover 421 of FIG. 9 may be substantially the same as the front cover 221 of FIGS. 3A and 3B, a repeated description will be omitted. According to an embodiment, the front cover 421 may be in contact with at least a part of the second surface 430d of the display 430. For example, the front cover 421 may be in contact with at least a part of the first region 430a among the first region 430a and the second region 430b of the display 430. According to an embodiment, the front cover 421 may be movable in a first direction (e.g., the +y direction) or a second direction (e.g., the -y direction) opposite to the first direction. For example, the front cover 421 may move in the first direction to be pulled out from the book cover 411 or may move in the second direction to be inserted into the book cover 411 in a state that at least a part of the front cover is surrounded by the display 430. The display 430 may move together with the front cover 421 according to the movement of the front cover 421.

According to an embodiment, the front cover 421 may include a rib 421a. The rib 421a may protect at least a part of the display 430. According to an embodiment, the rib 421a may surround at least one of the side surfaces 430e and 430f of the display 430 perpendicular to the moving direction of the display 430. For example, the rib 421a may face the first side surface 430e of the display 430 and be extended in a direction (e.g., the -z direction) from the second surface 430d of the display 430 to the first surface 430c. For example, when the electronic device 400 is assembled, the front cover 421 may be inserted into the book cover 411 while being surrounded by the display 430. In a case that the rib 421a is not included in the front cover 421, the side surfaces 430e and 430f of the display 430 may be exposed to the outside. As the side surfaces 430e and 430f of the display 430 are exposed to the outside, the side surfaces 430e and 430f of the display 430 may be damaged in case that the front cover 421 is inserted into the book cover 411. The electronic device 400 according to an embodiment may provide a structure capable of preventing damage to the display 430 by the rib 421a protecting the side surfaces 430e and 430f of the display 430.

Although FIG. 9 illustrates that the rib 421a surrounds only the first side surface 430e, this is for convenience of description. According to embodiments, the rib 421a may surround the first side surface 430e and the second side surface 430f.

As described above, the electronic device 400 according to an embodiment may provide a structure capable of preventing damage to the display 430 by the rib 421a protecting the side surfaces 430e and 430f of the display 430.

According to an embodiment, an electronic device (e.g., the electronic device 400 in FIG. 4A) may include a first housing (e.g., the first housing 410 in FIG. 4A), a second housing (e.g., the second housing 420 in FIG. 4A) coupled to the first housing to be slidable with respect to the first housing, a first region (e.g., a first region 430a of FIG. 4A) disposed on one surface of the second housing, a second region (e.g., a second region 430b of FIG. 4A) deformable by movement of the second housing, a display (e.g., the display 430 of FIG. 4A)(for example a flexible display), movable by the movement of the second housing (e.g. and configured to be slidable into the first housing or slidable out from the first housing by the movement of the second housing), and a plurality of supporting bars (e.g., a plurality of supporting bars 510 of FIG. 4A, 4B, and 4C) located on one surface of the display (e.g., the second surface 430d of FIG. 4B) and spaced apart from each other. According to an embodiment, the electronic device may include a plurality of barriers 530 disposed at one end of each of the plurality of supporting bars, extending in a direction perpendicular to the one surface of the display, and facing the side surface of the display (e.g., the first side surface 430e of FIG. 4A). According to an embodiment, the electronic device may include a plurality of guiding protrusions (e.g., a plurality of guiding protrusion 520 of FIG. 4C) extending in a direction opposite to an extension direction of the plurality of barriers from each of the plurality of supporting bars. According to an embodiment, a gap 11 between the side surfaces of each of the plurality of barriers facing each other is smaller than a gap l2 between the plurality of guiding protrusions. According to an embodiment, when a shape of a part of the display between the plurality of supporting bars is a plane surface, an interval between the side surfaces of each of the plurality of barriers facing each other may be smaller than an interval between the plurality of guiding protrusions. Advantageously, a smooth movement may be ensured.

According to an embodiment, the second housing may be movable between a first state inserted into the first housing and a second state pulled out from the first housing. According to an embodiment, each of the plurality of barriers may be disposed between the first housing and the side surface of the flexible display in the second state to block an inflow of foreign materials into an inner space defined by the first housing and the second housing. This ensures a high efficiency of blocking inflows of foreign materials.

According to an embodiment, at least one, in particular each, of the plurality of barriers may have a height longer than a thickness of the flexible display, and a size of a space between at least one of the plurality of barriers and the first housing may be smaller than a size of a gap between another surface (e.g., the first surface 430c of FIG. 4C) of the flexible display facing the (one) surface of the flexible display and the first housing. In particular, the other surface is directed oppositely and/or in parallel to the surface of the flexible display. This provides the advantage of ensuring a high efficiency of blocking inflows of foreign materials.

According to an embodiment, the plurality of supporting bars may include a first supporting bar (e.g., a first supporting bar 511 of FIGS. 5A and 5B) and a second supporting bar (e.g., a second supporting bar 512 of FIGS. 5A and 5B) spaced apart from each other. According to an embodiment, the plurality of barriers may include a first barrier (e.g., the first barrier 531 of FIGS. 5A and 5B) disposed at one end of the first supporting bar and a second barrier (e.g., the second barrier 532 of FIGS. 5A and 5B) disposed at one end of the second supporting bar. According to an embodiment, the first barrier may include a first extending portion (e.g., a first extending portion 533 of FIGS. 6A and 6B) facing the second region and extending in a direction parallel to a moving direction of the display. According to an embodiment, the first barrier may include a second extending portion (e.g., a second extending portion 534 of FIGS. 6A and 6B) extending longer than the first extending portion in a direction parallel to the first extending portion and/or a moving direction of the display. According to an embodiment, the second barrier may include a third extending portion (e.g., a third extending portion 535 of FIGS. 6A and 6B) facing the second region and extending in a direction parallel to a moving direction of the display. According to an embodiment, the second barrier may include a fourth extending portion (e.g., the fourth extending portion 536 of FIGS. 6A and 6B) extending shorter than the third extending portion in a direction parallel to a moving direction of the display. According to an embodiment, at least a part of the second extending portion may overlap at least a part of the third extending portion when the flexible display is viewed from the side surface. Advantageously, the inflow of foreign materials may be reduced.

According to an embodiment, a width of the second supporting bar may be smaller than the length of the third extending portion. According to an embodiment, a width of a part (e.g., a part 511p of FIG. 6A and FIG. 6B) of the first supporting bar facing the third extending portion may be smaller than a width of another part (e.g., another part 511o of FIG. 6A and FIG. 6B) of the first support bar.

According to an embodiment, each of the plurality of barriers may include a first extending portion (e.g., a first extending portion 533 of FIGS. 5A and 5B) facing the side surface of the flexible display and extending in a direction parallel to a moving direction of the flexible display. According to an embodiment, each of the plurality of barriers may include a second extending portion (e.g., a second extending portion 534 of FIGS. 5A and 5B) extending from one point of the first extending portion spaced apart from both ends (e.g., both ends 533a and 533b of FIGS. 5A and 5B) of the first extending portion among the points of the first extending portion. According to an embodiment, the second extending portion of a or one barrier among the plurality of barriers may overlap at least a part of the first extending portion of another barrier among the plurality of barriers when the flexible display is viewed from the side surface.

According to an embodiment, the electronic device may further include a guide rail (e.g., a guide rail 432 of FIG. 4C) disposed in the first housing and including a guide path for guiding movement of each of the plurality of guiding protrusion.

According to an embodiment, each of the plurality of guiding protrusions may include a connecting portion (e.g., a connecting portion 521 of FIG. 4C) extending in a direction perpendicular to the one surface of the display. According to an embodiment, each of the guiding protrusions may include a protruding portion (e.g., a connecting portion 522 of FIG. 4C) connected to the connecting portion and at least a part thereof may move in the guide path.

According to an embodiment, the plurality of guiding protrusions may include a first guiding protrusion (e.g., a first guiding protrusion 523 of FIG. 7) disposed in the first supporting bar, and a second guiding protrusion (e.g., the second guiding protrusion 524 in FIG. 7) disposed in the second supporting bar. According to an embodiment, when the shape of a part of the second region between the first supporting bar and the second supporting bar is a plane surface, an interval between the first barrier and the second barrier may be smaller than an interval between a part of the first guiding protrusion and a part of the second guiding protrusion. According to an embodiment, when the shape of a part of the second region between the first supporting bar and the second supporting bar is a curved surface, an interval between the first barrier and the second barrier may be greater than an interval between the first guiding protrusion and the second guiding protrusion.

According to an embodiment, the first housing may include a frame cover (e.g., a frame cover 413 of FIG. 4C) in contact with at least a part of the display. According to an embodiment, the guide rail may be disposed at a periphery of the frame cover facing a direction perpendicular to a moving direction of the second housing.

According to an embodiment, one surface (e.g., one surface 511a of FIG. 8) of each of the plurality of supporting bars facing the one surface of the display may be bent with respect to the one surface.

According to an embodiment, a or one surface (e.g., one surface 511a of FIG. 8) of each of the plurality of supporting bars facing the one surface of the display may include a plane surface (e.g., a plane surface 511b of FIG. 8) parallel to the one surface of the display and a curved surface (e.g., a curved surface 511c of FIG. 8) surrounding the plane surface curved with respect to the plane surface, and having a curvature.

According to an embodiment, the second housing may include a front cover (e.g., the front cover 421 of FIG. 9) in contact with at least a part of the (one) surface of the display. According to an embodiment, the front cover may include a rib (e.g., a rib 421a of FIG. 9) surrounding the side surface of the display.

According to an embodiment, the (one) surface of the display may face an inner space (e.g., an inner space 401 of FIG. 4C) of the electronic device defined by the first housing and the second housing. According to an embodiment, the display may be inserted into the inner space or may be pulled out from the inner space by the movement of the second housing.

According to an embodiment, the second region may be pulled out from the inside of the first housing as the second housing moves in the first direction, and may be inserted into the first housing as the second housing moves in a second direction opposite to the first direction.

According to an embodiment, the second housing may include a side surface (e.g., a side surface 220a of FIG. 2A) facing the first direction which is the moving direction of the second housing, and a distance between the side surface of the second housing and the first housing may increase as the second housing moves in the first direction, and may decrease as the second housing moves in a second direction opposite to the first direction.

According to an embodiment, an electronic device (e.g., the electronic device 400 of FIG. 4A) may include a first housing (e.g., the first housing 410 of FIG. 4A); a second housing (e.g., the second housing 420 of FIG. 4A) coupled to the first housing to be slidable with respect to the first housing; a display (e.g., the display 430 of FIG. 4A) including a first region (e.g., the first region 430a of FIG. 4A) disposed on one surface of the second housing and a second region (e.g., the second region 430b of FIG. 4A) deformable by a movement of the second housing, and movable by the movement of the second housing; and a guiding member (e.g., a guiding member 500 of FIG. 4B) including a first supporting bar (e.g., a first supporting bar 511 of FIGS. 5A and 5B) and a second supporting bar (e.g., the second supporting bar 512 of FIGS. 5A and 5B) extending in a direction parallel to one surface (e.g., the second surface 430d of FIG. 4B) of the display on the one surface of the display, spaced apart from each other, and disposed on the display. According to an embodiment, the guiding member may include a first barrier (e.g., the first barrier 531 of FIGS. 5A and 5B) extending from at least one of both ends of the supporting bar in a direction perpendicular to the one surface of the display, the first barrier includes a first extending portion (e.g., the first extending portion 533 of FIGS. 6A and 6B) facing the second region and extending in a direction parallel to a moving direction of the display, and a second extending portion (e.g., the second extending portion 534 of FIGS. 6A and 6B) parallel to the first barrier and extending longer than the first extending portion. According to an embodiment, the guiding member may include a second barrier (e.g., the second barrier 532 of FIGS. 5A and 5B) extending from at least one of both ends of the second supporting bar in the direction perpendicular to the one surface of the display, the second barrier includes a third extending portion (e.g., the third extending portion 535 of FIGS. 6A and 6B) facing the second region and extending in the direction parallel to the moving direction of the display, and a fourth extending portion (e.g., the fourth extending portion 536 of FIGS. 6A and 6B) parallel to the third extending portion and extending shorter than the third extending portion. According to an embodiment, at least a part of the second extending portion may overlap to at least a part of the third extending portion when the display is viewed from a side surface (e.g., the first side surface 430e of FIG. 4A) of the display parallel to the moving direction of the display. According to an embodiment, the first barrier and the second barrier may overlap a part of the first housing when the display is viewed from above.

According to an embodiment, the second housing may be movable between a first state inserted into the first housing, and a second state pulled out from the first housing. According to an embodiment, the first barrier and the second barrier may be disposed between the first housing and the side surface of the display in the second state.

According to an embodiment, a width of the second supporting bar may be smaller than the length of the third extending portion. According to an embodiment, a width of a part (e.g., a part 511p of FIG. 6A and FIG. 6B) of the first supporting bar facing the third extending portion may be smaller than a width of another part (e.g., another part 511o of FIGS. 6A and 6B) of the first support bar.

According to an embodiment, the electronic device may further include a guide rail (e.g., a guide rail 432 of FIG. 4C) including a guide path configured to guide a movement of the guiding member, and disposed in the housing. According to an embodiment, each of the first barrier and the second barrier may further include a guiding protrusion (e.g., guide protrusion 520 of FIG. 4C) movable within the guide path (e.g., guide path 432a in FIG. 4C) according to the movement of the second housing.

According to an embodiment, each of the guiding protrusions may include a connecting portion (e.g. connecting portion 521 in FIG. 4C) extending from the other surface (e.g., the first surface 430c of FIG. 4C) of the display facing the one surface of the display in a direction facing the one surface. According to an embodiment, each of the guiding protrusions may include a protruding portion (e.g., a connecting portion 522 of FIG. 4C) vertically connected to the connecting portion and at least a part thereof is inserted into the guide path.

According to an embodiment, the guiding protrusions may include a first guiding protrusion (e.g., a first guiding protrusion 523 in FIG. 7) disposed in the first supporting bar, and a second guiding protrusion (e.g., a second guiding protrusion 524 in FIG. 7) disposed in the second supporting bar. According to an embodiment, when the shape of a part of the second region between the first supporting bar and the second supporting bar is a plane surface, an interval between the first barrier and the second barrier may be smaller than an interval between a part of the first guiding protrusion and a part of the second guiding protrusion. According to an embodiment, when a part of the shape of the second region between the first supporting bar and the second supporting bar is a curved surface, an interval between the first barrier and the second barrier may be greater than an interval between the first guiding protrusion and the second guiding protrusion.

According to an embodiment, the first housing may include a frame cover (e.g., a frame cover 413 of FIG. 4C) surrounded by at least a part of the display. According to an embodiment, the guide rail may be disposed at a periphery of the frame cover facing a direction perpendicular to a moving direction of the second housing.

According to an embodiment, one surface (e.g., one surface 511a of FIG. 8) of the first supporting bar facing the one surface of the display may have a curvature.

According to an embodiment, one surface (e.g., one surface 511a of FIG. 8) of the first supporting bar facing the one surface of the display may include a plane surface (e.g., a plane surface 511b of FIG. 8) parallel to the one surface of the display, and a curved surface (e.g., a curved surface 511 of FIG. 8) surrounding the plane surface, curved with respect to the plane surface, and having a curvature.

According to an embodiment, the second housing may include a front cover (e.g., a front cover 421 of FIG. 9) in contact with at least a part of the one surface of the display. According to an embodiment, the front cover may include a rib (e.g., a rib 421a of FIG. 9) surrounding the side surface of the display.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (400) comprising:
a first housing (410);
a second housing (420) coupled to the first housing (410) to be slidable with respect to the first housing (410);
a flexible display (430) disposed on a surface of the second housing (420) and configured to be slidable into the first housing (410) or slidable out from the first housing (410) by a movement of the second housing (420);
a plurality of supporting bars (510) disposed on a surface (430d) of the flexible display (430), and spaced apart from each other;
a plurality of barriers (530) disposed on an one end of each of the plurality of supporting bars (530), extending in a direction perpendicular to the surface (430d) of the flexible display (430), and facing a side surface (430e, 430f) of the flexible display (430);
a plurality of guiding protrusions (520) extending from each of the plurality of supporting bars (510) in a direction opposite to the extending direction of the plurality of barriers (530); and
wherein a gap (11) between the side surfaces of each of the plurality of barriers (530) facing each other is smaller than a gap (l2) between the plurality of guiding protrusions (520).

2. The electronic device (400) of claim 1,
when the shape of a part of the flexible display (430) between the plurality of the supporting bars (510) is plane, the gap (11) between the side surfaces of each of the plurality of barriers (530) facing each other is smaller than the gap (l2) between the plurality of guiding protrusions (520).

3. The electronic device (400) of claim 1 or 2,
wherein the second housing (420) is configured to be movable between a first state inserted into the first housing (410) and a second state pulled out from the first housing (410), and
wherein each of the plurality of barriers (530) is disposed between the first housing (410) and the side surface (430e, 430f) of the flexible display (430) in the second state to block an inflow of foreign materials into an inner space (401) defined by the first housing (410) and the second housing (420).

4. The electronic device (400) of any one of the preceding claims,
wherein at least one of the plurality of barriers (530) has a height longer than a thickness of the flexible display (430),
wherein a size of a space (s1) between at least one of the plurality of barriers (530) and the first housing (410) is smaller than a size of a gap (g1) between another surface (430c) of the flexible display (430) facing the surface (430d) of the flexible display (430) and the first housing (410).

5. The electronic device (400) of any one of the preceding claims,
wherein the plurality of supporting bars (510) includes a first supporting bar (511) and a second supporting bar (512 spaced apart from each other,
wherein the plurality of barriers (530) includes a first barrier (531) disposed on an end of the first supporting bar (511) and a second barrier (532) disposed on an end of the second supporting bar (512),
wherein the first barrier includes (531):
a first extending portion (533) facing the side surface (430e, 430f) of the flexible display (430) and extending in a direction parallel to a moving direction of the flexible display (430);
a second extending portion (534) parallel to the first extending portion (533) and extending longer than the first extending portion (533);
wherein the second barrier includes (532):
a third extending portion (535) facing the side surface (430e, 430f) of the flexible display (430) and extending in the direction parallel to the moving direction of the flexible display (430);
a fourth extending portion (536) parallel to the third extending portion (535) and extending shorter than the third extending portion (535); and
wherein at least a part of the second extending portion (534) overlaps at least a part of the third extending portion (535) when the flexible display (430) is viewed from the side surface (430e, 430f).

6. The electronic device (400) of claim 5,
wherein a width of the second supporting bar (512) is smaller than the length of the third extending portion (535); and
wherein a width of a part (511p) of the first supporting bar (511) facing the third extending portion (535) is smaller than a width of another part (511o) of the first supporting bar (511).

7. The electronic device (400) of any one of the preceding claims,
wherein each of the plurality of barriers (530) includes:
a first extending portion (533) facing the side surface (430e, 430f) of the flexible display (430) and extending in a direction parallel to a moving direction of the flexible display (430);
a second extending portion extending from one point of the first extending portion spaced apart from both ends of the first extending portion among the points of the first extending portion; and
wherein the second extending portion (534) of a barrier among the plurality of barriers (530) overlaps at least a part of the first extending portion (533) of another barrier among the plurality of barriers (530) when the flexible display (430) is viewed from the side surface (430e, 430f).

8. The electronic device (400) of any one of the preceding claims, further including a guide rail (432) including a guide path (432a) configured to guide each of the plurality of guiding protrusions (520) and disposed in the first housing (410).

9. The electronic device (400) of claim 8,
wherein each of the plurality of guiding protrusions (520) includes:
a connecting portion (521) extending from another surface of the flexible display facing the one surface of the flexible display in a direction the one surface faces; and
a protruding portion (522) vertically connected to the connecting portion (521), wherein at least a part of the protruding portion (522) is inserted into the guide path (432a).

10. The electronic device (400) of claim 8 or 9,
wherein the first housing (410) includes a frame cover (413) surrounded by at least a part of the flexible display (430), and
wherein the guide rail (432) is disposed on a periphery of the frame cover (413) facing a direction perpendicular to a moving direction of the second housing (420).

11. The electronic device (400) of any one of the preceding claims,
wherein a surface (511a, 512a) facing the surface (430d) of the flexible display (430) of at least one of the plurality of the supporting bars (510) has a curvature.

12. The electronic device (400) of any one of the preceding claims,
wherein a surface (511a, 512a) of each of the plurality of supporting bars (510) facing the surface (430d) of the flexible display (430) includes:
a plane surface (511b) in contact with the surface (430d) of the flexible display (430); and
a curved surface (511c) connected to the plane surface (511b) and bent with respect to the plane surface (511b) to have a curvature.

13. The electronic device (400) of any one of the preceding claims,
wherein the second housing (420) includes a front cover (421) in contact with at least a part of the surface (430d) of the flexible display (430), and
wherein the front cover (421) includes a rib (421a) surrounding the side surface (430e, 430f) of the flexible display (430).

14. The electronic device (400) of any one of the preceding claims,
wherein the surface (430d) of the flexible display (430) faces an inner space (401) of the electronic device (400) formed by the first housing (410) and the second housing (420), and
wherein the flexible display (430) is configured to be inserted into the inner space (401) or is pulled out from the inner space (401) by the movement of the second housing (420).

15. The electronic device (400) of any one of the preceding claims,
wherein a part of the flexible display (430) is configured to be pulled out from an inside of the first housing (410) as the second housing (420) moves along a first direction, and inserted into the inside of the first housing (410) as the second housing (420) moves along a second direction opposite to the first direction.
